# FASCICULE DE BREVET EUROPEEN

(11) **EP 3 627 103 B1**
(45) Date de publication et mention de la délivrance du brevet: **09.02.2022**
(21) Numéro de dépôt: 19198100.0
(22) Date de dépôt: 18.09.2019
(51) Int. Cl.: G01C 21/00, G01F 1/684, G01F 1/696, G01F 1/69, G01F 1/692, G01P 5/12, G01F 1/698

(54) **DISPOSITIF DE MESURE COMPORTANT UN FIL SEMICONDUCTEUR SUSPENDU**
MESSVORRICHTUNG, DIE EINEN AUFGEHÄNGTEN HALBLEITERDRAHT UMFASST
MEASURING DEVICE COMPRISING A SUSPENDED SEMICONDUCTOR WIRE

(30) Priorité: 21.09.2018 FR 1858604
(43) Date de publication de la demande: 25.03.2020
(73) Titulaire: COMMISSARIAT À L'ÉNERGIE ATOMIQUE ET AUX ÉNERGIES ALTERNATIVES, 75015 Paris (FR); SAFRAN, 75015 Paris (FR)
(72) Inventeur: FAIN, Bruno, 38054 Grenoble Cedex 9 (FR); JOURDAN, Guillaume, 38054 Grenoble Cedex 9 (FR); LEHEE, Guillaume, 92100 Boulogne-Billancourt (FR)
(74) Mandataire: Cabinet Beaumont

(56) Documents cités:
- US-A- 5 861 556
- US-A1- 2008 224 717
- US-A1- 2015 175 413
- Wikipedia: "Four-terminal sensing", Wikipedia, 16 September 2018 (2018-09-16), pages 1-3, XP055772992, Retrieved from the Internet: URL:https://en.wikipedia.org/w/index.php?t itle=Four-terminal_sensing&oldid=859823801 [retrieved on 2021-02-05]

## Description

### Domaine

La présente demande concerne le domaine des dispositifs de mesure à base de fils semiconducteurs suspendus.

### Exposé de l'art antérieur

On a déjà proposé des dispositifs de mesure dans lesquels un nanofil ou un microfil semiconducteur suspendu est utilisé pour la mesure d'une grandeur physique caractéristique de l'environnement du fil, par exemple la température au voisinage du fil, la conductivité thermique et/ou la pression d'un gaz en contact avec le fil, une déformation mécanique, etc.

Dans ces dispositifs, le fil semiconducteur joue le rôle d'un transducteur résistif. Autrement dit, les variations de la grandeur physique à mesurer se traduisent par des variations de la résistance électrique du fil. Le dispositif de mesure comprend un circuit de contrôle adapté à mesurer des variations de la résistance électrique du fil et à en déduire des variations de la grandeur physique à mesurer.

Le document US5861556 décrit un dispositif de mesure de flux à base de fils semiconducteurs suspendus.

Il serait souhaitable de pouvoir améliorer au moins en partie certains aspects des dispositifs de mesure connus à base de fils semiconducteurs suspendus.

### Résumé

Ainsi, un mode de réalisation prévoit un dispositif de mesure selon la revendication 1

Selon un mode de réalisation, les première et deuxième extrémités du fil semiconducteur suspendu sont fixées respectivement à des première et deuxième régions semiconductrices d'ancrage, le dispositif comportant une première borne conductrice sur et en contact avec la première région d'ancrage et une deuxième borne conductrice sur et en contact avec la deuxième région d'ancrage, et le premier circuit de contrôle étant connecté aux première et deuxième bornes conductrices.

Selon un mode de réalisation, les première et deuxième régions d'ancrage reposent respectivement sur des premier et deuxième piliers de support.

Selon un mode de réalisation :
le premier fil sonde a une première extrémité fixée au premier fil semiconducteur suspendu au niveau de son premier noeud intermédiaire et une deuxième extrémité fixée à une troisième région semiconductrice d'ancrage ;
le deuxième fil sonde a une première extrémité fixée au premier fil semiconducteur suspendu au niveau de son deuxième noeud intermédiaire et une deuxième extrémité fixée à une quatrième région semiconductrice d'ancrage ; et
les troisième et quatrième bornes conductrices sont respectivement sur et en contact avec la troisième région d'ancrage et sur et en contact avec la quatrième région d'ancrage.

Selon un mode de réalisation, les troisième et quatrième régions d'ancrage reposent respectivement sur des troisième et quatrième piliers de support de façon que le premier fil sonde soit suspendu entre le troisième pilier de support et le premier noeud intermédiaire du fil semiconducteur suspendu et que le deuxième fil sonde soit suspendu entre le quatrième pilier de support et le deuxième noeud intermédiaire du fil semiconducteur suspendu.

Selon un mode de réalisation, la largeur du premier fil semiconducteur suspendu varie le long de l'axe longitudinal du fil de façon que, en fonctionnement, la température entre les premier et deuxième noeuds intermédiaires du fil semiconducteur suspendu soit sensiblement uniforme.

Selon un mode de réalisation, le dispositif comprend une pluralité de fils semiconducteurs suspendus interconnectés de façon à former une grille semiconductrice suspendue.

Selon un mode de réalisation, la densité de fils semiconducteurs suspendus de la grille varie selon un axe longitudinal de la grille.

Selon un mode de réalisation, le deuxième circuit de mesure comprend un premier amplificateur de mesure de tension ayant une première borne de mesure reliée au premier noeud intermédiaire du fil semiconducteur suspendu et une deuxième borne de mesure reliée au deuxième noeud intermédiaire du fil semiconducteur suspendu, le premier amplificateur de mesure de tension comportant en outre une borne de sortie reliée à la première extrémité du fil semiconducteur suspendu par une première résistance.

Selon un mode de réalisation, le dispositif comporte en outre un deuxième amplificateur de mesure de tension et un additionneur de tension, et :
le deuxième amplificateur de mesure de tension a des première et deuxième bornes de mesure reliées respectivement à des première et deuxième extrémités d'une deuxième résistance connectée en série avec le fil semiconducteur suspendu ;
l'additionneur de tension a des première et deuxième bornes d'entrée reliées respectivement à la borne de sortie du premier amplificateur et à une borne de sortie du deuxième amplificateur ; et
l'additionneur de tension comporte une borne de sortie reliée à la première extrémité du fil semiconducteur suspendu par la première résistance.

Selon un mode de réalisation, en fonctionnement, une première partie du courant de polarisation circule dans le fil semiconducteur suspendu et une deuxième partie du courant de polarisation est dérivée par la première résistance, les valeurs des première et deuxième parties du courant de polarisation étant fonction de la valeur de la tension sur l'extrémité de la première résistance opposée à la première extrémité du fil semiconducteur suspendu.

Selon un mode de réalisation, le courant de polarisation fourni par le premier circuit de contrôle est choisi de façon qu'il existe deux états de polarisation stables du dispositif, c'est-à-dire deux répartitions possibles du courant de polarisation entre le fil semiconducteur suspendu et la première résistance.

Selon un mode de réalisation, le deuxième circuit de contrôle est configuré pour détecter un changement brusque de l'état de polarisation du dispositif, correspondant à un franchissement d'un seuil par une grandeur physique caractéristique de l'environnement du fil semiconducteur.

Selon un mode de réalisation, le premier circuit de contrôle est configuré pour fournir un courant de polarisation variable de façon périodique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective illustrant de façon schématique un exemple d'un dispositif de mesure comportant un fil semiconducteur suspendu ;
la figure 2 est une vue de dessus illustrant de façon schématique un exemple d'un mode de réalisation d'un dispositif de mesure comportant un fil semiconducteur suspendu ;
les figures 3A et 3B sont des diagrammes illustrant la réponse électrique d'un fil semiconducteur suspendu d'un dispositif de mesure du type décrit en relation avec la figure 2 ;
la figure 4 est un schéma électrique équivalent d'un exemple d'un mode de réalisation d'un dispositif de mesure comportant un fil semiconducteur suspendu ;
la figure 5 est un schéma thermique équivalent d'un exemple d'un mode de réalisation d'un dispositif de mesure comportant un fil semiconducteur suspendu ;
la figure 6 est une vue de dessus illustrant de façon schématique un autre exemple d'un mode de réalisation d'un dispositif de mesure comportant un fil semiconducteur suspendu ;
la figure 7 est une vue de dessus illustrant de façon schématique un autre exemple d'un mode de réalisation d'un dispositif de mesure comportant un fil semiconducteur suspendu ;
la figure 8 est une vue de dessus illustrant de façon schématique un autre exemple d'un mode de réalisation d'un dispositif de mesure comportant un fil semiconducteur suspendu ;
la figure 9 est une vue de dessus illustrant de façon schématique un autre exemple d'un mode de réalisation d'un dispositif de mesure comportant un fil semiconducteur suspendu ;
la figure 10 est une vue de dessus illustrant de façon schématique un autre exemple d'un mode de réalisation d'un dispositif de mesure comportant un fil semiconducteur suspendu ;
la figure 11 est un schéma électrique simplifié d'un exemple d'un mode de réalisation d'un dispositif de mesure comportant un fil semiconducteur suspendu ;
les figures 12, 13 et 14 sont des diagrammes illustrant le fonctionnement du dispositif de mesure de la figure 11 ;
la figure 15 est un schéma électrique simplifié d'un autre exemple d'un mode de réalisation d'un dispositif de mesure comportant un fil semiconducteur suspendu ;
la figure 16 est un diagramme illustrant le fonctionnement du dispositif de mesure de la figure 15 ;
la figure 17 est un diagramme illustrant le fonctionnement d'un exemple d'un mode de réalisation d'un dispositif de mesure comportant un fil semiconducteur suspendu ;
la figure 18 est une vue de dessus illustrant de façon schématique un autre exemple d'un mode de réalisation d'un dispositif de mesure comportant un fil semiconducteur suspendu ; et
les figures 19A, 19B, 19C, 19D, 19E, 19F, 19G et 19H sont des vues en coupe illustrant de façon schématique des étapes successives d'un exemple d'un procédé de fabrication d'un dispositif de mesure comportant un fil semiconducteur suspendu.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les diverses applications que peuvent avoir les dispositifs de mesure décrits n'ont pas été détaillées, les modes de réalisation décrits pouvant avantageusement être utilisés dans toutes ou la plupart des applications de mesure utilisant la réponse électrique d'un fil semiconducteur suspendu pour mesurer des variations d'une grandeur physique caractéristique de l'environnement du fil. De plus, les dispositifs décrits peuvent être utilisés pour la caractérisation de fils semiconducteurs, notamment lors de la conception de capteurs à base de fils semiconducteurs suspendus. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près.

La présente demande concerne plus particulièrement des dispositifs de mesure à base de nanofils ou de microfils semiconducteurs suspendus, par exemple des fils dont la plus grande dimension, en section transversale (orthogonalement à la direction longitudinale du fil), est inférieure à 10 µm, de préférence inférieure à 1 µm, de préférence inférieure à 500 nm. Par souci de simplification, on utilisera le terme fil dans la suite de la description pour désigner de tels nanofils ou microfils. Dans la présente description, le terme fil désigne de façon générale tout élément de forme générale allongée, c'est-à-dire dont la longueur (c'est-à-dire la plus grande dimension) est significativement supérieure, par exemple au moins deux fois supérieure, de préférence au moins cinq fois supérieure, de préférence au moins dix fois supérieure, à la plus grande largeur, c'est-à-dire à la plus grande dimension en section transversale (dans un plan orthogonal à l'axe longitudinal du fil). Dans les dispositifs décrits, la largeur des fils peut être constante le long de l'axe longitudinal du fil, ou variable le long de l'axe longitudinal du fil.

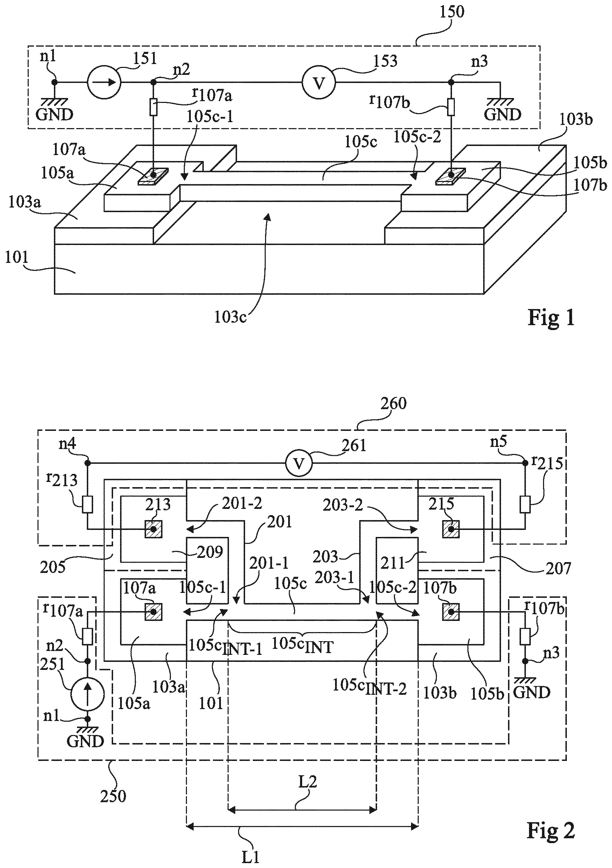

La figure 1 est une vue en perspective illustrant de façon schématique un exemple d'un dispositif de mesure comportant un fil semiconducteur suspendu. Cet example ne fait pas partie de l'invention revendiquée.

Le dispositif de la figure 1 comprend un substrat de support 101, par exemple en un matériau semiconducteur, par exemple en silicium. Le dispositif de la figure 1 comprend en outre, sur la face supérieure du substrat 101, par exemple en contact avec la face supérieure du substrat 101, deux piliers ou plots 103a et 103b, par exemple en un matériau isolant, par exemple en oxyde de silicium. Les piliers 103a et 103b sont séparés latéralement par une région 103c libre de tout matériau solide. Le dispositif de la figure 1 comprend en outre un fil 105c en un matériau semiconducteur, par exemple en silicium, suspendu entre les piliers 103a et 103b au-dessus de la région 103c. Dans l'exemple représenté, l'axe longitudinal du fil 105c est sensiblement parallèle à la face supérieure du substrat 101. On appellera ici largeur du fil la dimension transversale du fil (orthogonale à l'axe longitudinal du fil) parallèle à la face supérieure du substrat 101, et épaisseur du fil la dimension transversale du fil orthogonale à la face supérieure du substrat 101. Dans l'exemple représenté, l'épaisseur et la largeur du fil sont sensiblement constantes sur toute la longueur du fil. Le fil 105c est fixé, du côté d'une première extrémité 105c-1, à la face supérieure du pilier 103a, et, du côté d'une deuxième extrémité 105c-2, à la face supérieure du pilier 103b. Dans l'exemple représenté, du côté de sa première extrémité 105c-1, le fil 105c se prolonge par une région d'ancrage 105a, par exemple en le même matériau que le fil 105c, dont la face inférieure repose sur la face supérieure du pilier 103a, par exemple en contact avec la face supérieure du pilier 103a. De plus, dans cet exemple, du côté de sa deuxième extrémité 105c-2, le fil 105c se prolonge par une région d'ancrage 105b, par exemple en le même matériau que le fil 105c, dont la face inférieure repose sur la face supérieure du pilier 103b, par exemple en contact avec la face supérieure du pilier 103b. Le dispositif de la figure 1 comprend de plus une métallisation de prise de contact 107a, sur et en contact avec la face supérieure de la région d'ancrage 105a, et une métallisation de prise de contact 107b sur et en contact avec la face supérieure de la région d'ancrage 105b. Les métallisations de prise de contact 107a et 107b permettent d'appliquer et/ou de lire un signal électrique entre les extrémités du fil 105c.

Le dispositif de mesure de la figure 1 comprend en outre un circuit de contrôle 150 connecté d'une part à la métallisation 107a et d'autre part à la métallisation 107b, adapté à appliquer et/ou lire un signal électrique entre les extrémités du fil 105c. Plus particulièrement, dans cet exemple, le circuit de contrôle 150 est adapté à faire circuler un courant électrique dans le fil 105c, entre ses première et deuxième extrémités, et à mesurer une tension entre les première et deuxième extrémités du fil. Pour cela, dans l'exemple représenté, le circuit de contrôle 150 comprend une source de courant 151 et un capteur de tension 153. La source de courant 151 est connectée en série avec le fil 105c, et le capteur de tension 153 est connecté en parallèle avec le fil 105c. Plus particulièrement, dans l'exemple représenté, la source de courant 151 comprend une première borne de conduction connectée à un noeud n1 du circuit 150 et une deuxième borne de conduction connecté à un noeud n2 du circuit 150, et le capteur de tension 153 comprend une première borne de mesure connectée au noeud n2 et une deuxième borne de mesure connectée à un noeud n3 du circuit 150. Sur le schéma de la figure 1, des résistances d'accès r₁₀₇ₐ et r_{107b} ont été représentées. La résistance r₁₀₇ₐ relie le noeud n2 à la métallisation 107a et la résistance r_{107b} relie le noeud n3 à la métallisation 107b. Les résistances r₁₀₇ₐ et r_{107b} correspondent aux résistances parasites d'accès du circuit de contrôle 150, comprenant notamment les résistances des pistes conductrices de connexion du circuit de contrôle au fil semiconducteur 105c. Les noeuds n1 et n3 sont par exemple reliés à un noeud GND d'application d'un potentiel de référence du dispositif de mesure, par exemple la masse.

A titre d'exemple, en fonctionnement, le circuit de contrôle 150 peut appliquer un courant déterminé dans le fil semiconducteur 105c, et mesurer la tension résultante aux bornes du fil. Le circuit de contrôle 150 peut ainsi mesurer des variations de résistance du fil 105c, et en déduire des variations d'une grandeur physique caractéristique de l'environnement du fil.

Les fils semiconducteurs sont tout particulièrement avantageux dans des dispositifs de mesure à transduction résistive. En particulier, en raison de leurs faibles dimensions et des effets particuliers, dans le matériau semiconducteur les constituant, liés à leurs dimensions micrométriques ou nanométriques, ils permettent d'atteindre des sensibilités de mesure particulièrement élevées, avec une forte densité d'intégration.

Toutefois, l'utilisation de tels fils semiconducteurs pour réaliser des mesures nécessite un bon contrôle de leur réponse électrique. En particulier, certaines propriétés du matériau semiconducteur constitutif du fil, comme sa résistivité électrique et sa conductivité thermique, sont généralement fortement dépendantes de la température, qui dépend elle-même des conditions de polarisation électrique du fil. En effet, les faibles dimensions du fil induisent un fort auto-échauffement par effet Joule lorsque celui-ci est polarisé. Cet auto-échauffement n'est par ailleurs pas uniforme dans le fil. En particulier, l'auto-échauffement du fil sous l'effet de sa polarisation électrique est généralement plus important dans un tronçon central du fil qu'au voisinage des régions d'ancrage du fil (les régions d'ancrage se comportant comme des dissipateurs thermiques limitant l'élévation de température du fil au voisinage de ses extrémités). De plus, des variations de propriété du matériau semiconducteur en fonction de la température peuvent conduire à amplifier le phénomène d'auto-échauffement de manière parfois difficilement prédictible.

Dans la pratique, la réponse électrique du fil peut avoir un comportement fortement non linéaire, voire non monotone. Ce comportement s'explique notamment par le changement de régime de conduction dans le matériau semiconducteur constitutif du fil lorsque la température varie. Plus particulièrement, lorsque la température du matériau semiconducteur est relativement basse, le régime de conduction électrique dans le matériau est un régime de conduction dit extrinsèque, c'est-à-dire que la conductivité électrique est liée essentiellement à la concentration en dopants dans le matériau. Lorsque la température du matériau semiconducteur augmente, le régime de conduction extrinsèque est remplacé par un régime de conduction intrinsèque, c'est-à-dire dans lequel la conductivité électrique est sensiblement indépendante de la concentration en dopants dans le matériau. En pratique, ce changement de régime de conduction s'opère d'abord dans les zones les plus chaudes du fil semiconducteur, généralement au milieu du fil, puis la zone de conduction intrinsèque s'étend progressivement en direction des extrémités du fil lorsque la température du fil augmente. Certaines portions du fil, notamment au voisinage des extrémités du fil, peuvent rester en permanence relativement froides (en raison des pertes thermiques par les régions d'ancrage), de sorte que ces zones restent toujours en régime de conduction extrinsèque.

Une limitation du dispositif de mesure de la figure 1 est que la source de courant 151 et le capteur de tension 153 sont reliés électriquement à l'extrémité 105c-1 du fil semiconducteur 105c par une même métallisation de contact 107a et sont reliés électriquement à l'extrémité 105c-2 du fil par une même métallisation de contact 107b. Ceci simplifie la conception et l'implémentation du dispositif de mesure. Toutefois, la mesure de résistance du fil 105c mise en oeuvre par le circuit de contrôle 150 intègre alors les résistances d'accès r₁₀₇ₐ et r_{107b} en série avec le fil 105c. Ceci conduit à limiter la précision et la sensibilité en température du dispositif de mesure. De plus, la mesure réalisée donne une information globale sur la résistance électrique du fil, qui ne tient pas compte des variations locales du comportement du fil le long de son axe longitudinal (liées aux variations de température du fil le long de son axe longitudinal) .

La figure 2 est une vue de dessus illustrant de façon schématique un exemple d'un mode de réalisation d'un dispositif de mesure comportant un fil semiconducteur suspendu. Le dispositif de mesure de la figure 2 comprend des éléments communs avec le dispositif de mesure de la figure 1. Ces éléments ne seront pas détaillés à nouveau ci-après. Dans la suite, seules les différences avec le dispositif de mesure de la figure 1 seront mises en exergue.

Le dispositif de la figure 2 comprend, comme dans l'exemple de la figure 1, un fil semiconducteur 105c suspendu entre deux piliers 103a et 103b au-dessus d'un substrat de support 101. Comme dans l'exemple de la figure 1, le fil 105c est fixé, par sa première extrémité 105c-1, à une région d'ancrage 105a reposant sur le pilier 103a, et, par sa deuxième extrémité 105c-2, à une région d'ancrage 105b reposant sur le pilier 103b. De plus, comme dans l'exemple de la figure 1, le dispositif comprend une métallisation de prise de contact 107a, sur et en contact avec la face supérieure de la région d'ancrage 105a, et une métallisation de prise de contact 107b sur et en contact avec la face supérieure de la région d'ancrage 105b.

Le dispositif de la figure 2 comprend en outre un premier circuit de contrôle 250 connecté d'une part à la métallisation 107a et d'autre part à la métallisation 107b, adapté à appliquer un signal électrique entre les extrémités du fil 105c. Le circuit de contrôle 250 est adapté à faire circuler un courant électrique dans le fil 105c, entre ses extrémités 105c-1 et 105c-2. Pour cela, dans l'exemple représenté, le circuit de contrôle 250 comprend une source de courant 251 connectée en série avec le fil 105c. Plus particulièrement, dans l'exemple représenté, la source de courant 251 comprend une première borne de conduction connectée à un noeud n1 du circuit 250 et une deuxième borne de conduction connecté à un noeud n2 du circuit 250. Sur le schéma de la figure 2, des résistances d'accès r₁₀₇ₐ et r_{107b} ont été représentées. La résistance r₁₀₇ₐ relie le noeud n2 à la métallisation 107a et la résistance r_{107b} relie la métallisation 107b à un noeud n3 du circuit 250. Les résistances r₁₀₇ₐ et r_{107b} correspondent aux résistances parasites d'accès du circuit de contrôle 250, comprenant notamment les résistances des pistes conductrices de connexion du circuit de contrôle 250 au fil semiconducteur 105c. Les noeuds n1 et n3 sont par exemple connectés. Dans l'exemple représenté, les noeuds n1 et n3 sont reliés à un même noeud GND d'application d'un potentiel de référence du dispositif de mesure, par exemple la masse.

Le dispositif de la figure 2 comprend en outre un deuxième circuit de contrôle 260 agencé pour lire un deuxième signal électrique aux bornes d'un tronçon intermédiaire 105c_{INT} du fil semiconducteur 105c, situé entre les extrémités 105c-1 et 105c-2 du fil. La longueur L2 du tronçon intermédiaire 105c_{INT} du fil 105c est inférieure à la longueur L1 du fil 105c, par exemple comprise entre 0,2 et 0,8 fois la longueur L1. Le tronçon 105c_{INT} s'étend entre un premier noeud intermédiaire 105c_{INT-1} du fil 105c, situé entre les extrémités 105c-1 et 105c-2 du fil, et un deuxième noeud intermédiaire 105c_{INT-2} du fil 105c, situé entre le noeud 105c_{INT-1} et l'extrémité 105c-2 du fil. Le tronçon intermédiaire 105c_{INT} est par exemple centré sur le milieu du fil 105c, c'est-à-dire que la distance entre l'extrémité 105c_{INT-1} du tronçon intermédiaire 105c_{INT} et l'extrémité 105c-1 du fil 105c est sensiblement égale à la distance entre l'extrémité 105c_{INT-2} du tronçon 105c_{INT} et l'extrémité 105c-2 du fil 105c.

Dans l'exemple de la figure 2, le dispositif de mesure comprend deux fils semiconducteurs suspendus additionnels ou fils sondes 201 et 203, distincts du fil 105c, reliant respectivement la première extrémité 105c_{INT-1} du tronçon intermédiaire 105c_{INT} du fil 105c à une première borne du circuit de contrôle 260, et la deuxième extrémité 105c_{INT-2} du tronçon intermédiaire 105c_{INT} du fil 105c à une deuxième borne du circuit de contrôle 260. Les fils sondes 201 et 203 sont par exemple en le même matériau semiconducteur que le fil 105c.

Le fil semiconducteur 201 est suspendu au-dessus du substrat 101, parallèlement à la face supérieure du substrat 101, entre l'extrémité 105c_{INT-1} du tronçon intermédiaire 105c_{INT} du fil 105c et un pilier ou plot 205, par exemple en un matériau isolant, par exemple en oxyde de silicium, disposé sur la face supérieure du substrat 101, par exemple en contact avec la face supérieure du substrat 101. Dans l'exemple représenté, le pilier 205 est juxtaposé au pilier 103a. Le fil 201 a une première extrémité 201-1 en contact mécaniquement et électriquement avec le fil 105c au niveau du noeud intermédiaire 105c_{INT-1} du fil 105c. Le fil semiconducteur 201 constitue une dérivation du fil 105c, partant du fil 105c au niveau du noeud intermédiaire 105c_{INT-1}. Du côté d'une deuxième extrémité 201-2, le fil 201 est fixé à la face supérieure du pilier 205. Plus particulièrement, dans cet exemple, du côté de son extrémité 201-2, le fil 201 se prolonge par une région d'ancrage 209 distincte (et disjointe) de la région d'ancrage 105a, par exemple en le même matériau que le fil 201, dont la face inférieure repose sur la face supérieure du pilier 205, par exemple en contact avec la face supérieure du pilier 205.

Le fil semiconducteur 203 est suspendu au-dessus du substrat 101, parallèlement à la face supérieure du substrat 101, entre l'extrémité 105c_{INT-2} du tronçon intermédiaire 105c_{INT} du fil 105c et un pilier ou plot 207, par exemple en un matériau isolant, par exemple en oxyde de silicium, disposé sur la face supérieure du substrat 101, par exemple en contact avec la face supérieure du substrat 101. Dans l'exemple représenté, le pilier 207 est juxtaposé au pilier 103b. Le fil 203 a une première extrémité 203-1 en contact mécaniquement et électriquement avec le fil 105c au niveau du noeud intermédiaire 105c_{INT-2} du fil 105c. Le fil semiconducteur 203 constitue une dérivation du fil 105c, partant du fil 105c au niveau du noeud intermédiaire 105c_{INT-2}. Du côté d'une deuxième extrémité 203-2, le fil 201 est fixé à la face supérieure du pilier 207. Plus particulièrement, dans cet exemple, du côté de son extrémité 203-2, le fil 203 se prolonge par une région d'ancrage 211 distincte (et disjointe) de la région d'ancrage 105b, par exemple en le même matériau que le fil 203, dont la face inférieure repose sur la face supérieure du pilier 207, par exemple en contact avec la face supérieure du pilier 207.

Le dispositif de la figure 2 comprend de plus une métallisation de prise de contact 213, sur et en contact avec la face supérieure de la région d'ancrage 209, et une métallisation de prise de contact 215 sur et en contact avec la face supérieure de la région d'ancrage 211. Les métallisations de prise de contact 213 et 215 permettent d'appliquer et/ou de lire un signal électrique entre les noeuds intermédiaire 105c_{INT-1} et 105c_{INT-2} du fil 105c, par l'intermédiaire des fils semiconducteurs 201 et 203.

Dans l'exemple de la figure 2, le circuit de contrôle 260 est connecté d'une part à la métallisation 213 et d'autre part à la métallisation 215. Le circuit de contrôle est adapté à mesurer un signal électrique entre les métallisations 213 et 215, c'est-à-dire aux bornes de l'association en série du fil 201, du tronçon intermédiaire 105c_{INT} du fil 105c, et du fil 203. Plus particulièrement, dans cet exemple, le circuit de contrôle 260 est adapté à mesurer la tension entre les métallisations 213 et 215 du dispositif. Pour cela, le circuit de contrôle 260 comprend un capteur de tension 261, par exemple un voltmètre, ayant une première borne de mesure connectée à un noeud n4 du circuit 260 et une deuxième borne de mesure connectée à un noeud n5 du circuit 260. Sur le schéma de la figure 2, des résistances d'accès r₂₁₃ et r₂₁₅ ont été représentées. La résistance r₂₁₃ relie le noeud n4 à la métallisation 213 et la résistance r₂₁₅ relie le noeud n5 à la métallisation 215. Les résistances r₂₁₃ et r₂₁₅ correspondent aux résistances parasites d'accès du circuit de contrôle 260, comprenant notamment les résistances des pistes conductrices de connexion du circuit de contrôle à l'extrémité 201-2 du fil semiconducteur 201 et à l'extrémité 203-2 du fil semiconducteur 203.

En fonctionnement, le circuit de contrôle 250 applique un courant déterminé dans le fil semiconducteur 105c, et donc dans le tronçon intermédiaire 105c_{INT} du fil 105c, et le circuit de contrôle 260 mesure la tension résultante aux bornes du tronçon intermédiaire 105c_{INT} (par l'intermédiaire des fils semiconducteurs sondes 201 et 203). Les circuits de contrôle 250 et 260 permettent ainsi de mesurer des variations de résistance du tronçon intermédiaire 105c_{INT} du fil 105c, et d'en déduire des variations d'une grandeur physique caractéristique de l'environnement du fil. A titre d'exemple, le dispositif de mesure de la figure 2 peut comprendre une unité de traitement et de contrôle, non représentée, configurée pour commander les circuits de contrôle 250 et 260 et lire et traiter les signaux mesurés par le circuit de contrôle 250 et/ou par le circuit de contrôle 260.

Un avantage du dispositif de mesure de la figure 2 est qu'il permet de mesurer des variations de résistivité du tronçon intermédiaire 105c_{INT} du fil semiconducteur 105c, indépendamment des variations de résistivité au voisinage des extrémités du fil (c'est-à-dire entre l'extrémité 105c-1 et le noeud intermédiaire 105c_{INT-1} du fil 105c et entre l'extrémité 105c-2 et le noeud intermédiaire 105c_{INT-2} du fil 105c). Ceci permet d'améliorer la précision et la sensibilité du dispositif de mesure. En particulier, le profil de température du tronçon intermédiaire 105c_{INT} du fil 105c peut être contrôlé avec précision par le choix des conditions de polarisation électrique. Plus particulièrement, pour un courant de polarisation donné, la température du tronçon intermédiaire 105c_{INT} du fil 105c peut être nettement plus uniforme que la température du fil 105c complet, et la température moyenne du tronçon intermédiaire 105c_{INT} du fil 105c peut être nettement plus élevée que la température moyenne du fil 105c complet. Ainsi, les variations de la grandeur physique que l'on cherche à mesurer peuvent être déduites avec une grande précision des variations de la résistance du tronçon intermédiaire 105c_{INT} du fil 105c. On peut notamment prévoir de polariser le fil 105c de façon que des variations de la grandeur physique que l'on cherche à mesurer conduisent à un changement du régime de conduction dans le tronçon intermédiaire 105c_{INT} du fil 105c, ce qui permet de détecter particulièrement efficacement lesdites variations.

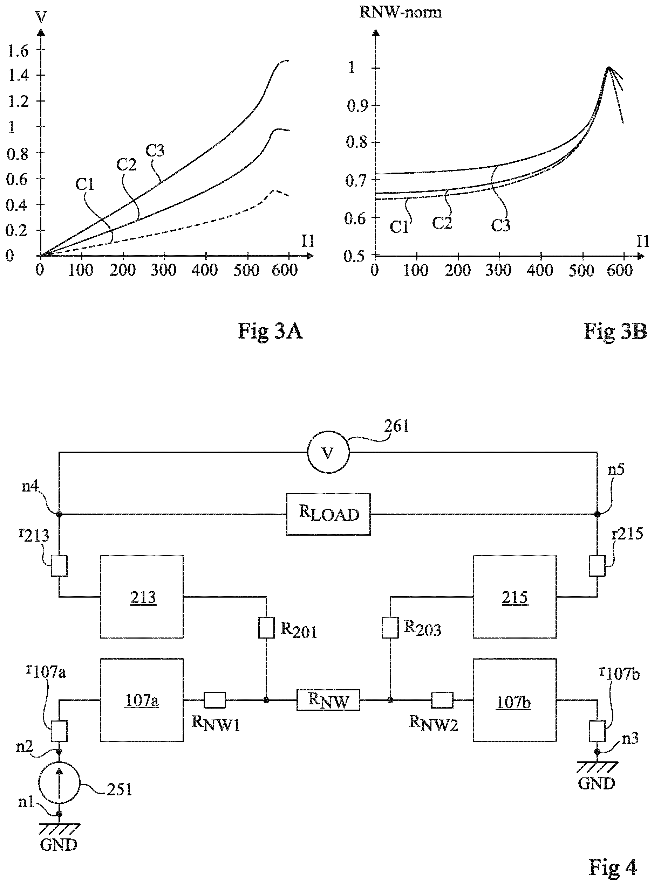

Les figures 3A et 3B sont des diagrammes illustrant le fonctionnement du dispositif de mesure de la figure 2. Plus particulièrement, la figure 3A représente l'évolution, en fonction du courant de polarisation I1 (en abscisse, en microampères) appliqué dans le fil 105c par le dispositif de contrôle 250, de la tension V (en ordonnée, en volts) mesurée aux bornes du tronçon intermédiaire 105c_{INT} du fil 105c par le dispositif de contrôle 260. La figure 3B est un diagramme équivalent représentant l'évolution, en fonction du courant de polarisation I1 (en abscisse, en microampères) appliqué dans le fil 105c par le dispositif de contrôle 250, de la résistance R_{NW-norm} du tronçon intermédiaire 105c_{INT} du fil 105c, normalisée par rapport à sa valeur maximale (en ordonnée, sans unité). Chacun des diagrammes des figures 3A et 3B comprend trois courbes C1, C2 et C3. Dans chaque diagramme, la courbe C1 correspond à une première configuration du dispositif de mesure, dans laquelle la longueur L2 du tronçon intermédiaire 105c_{INT} est égale à 0,31 fois la longueur L1 du fil 105c. La courbe C2 correspond à une deuxième configuration du dispositif de mesure, dans laquelle la longueur L2 du tronçon intermédiaire 105c_{INT} est égale à 0,61 fois la longueur L1 du fil 105c. La courbe C3 correspond à une troisième configuration du dispositif de mesure ou configuration de référence, dans laquelle la longueur L2 du tronçon intermédiaire 105c_{INT} est égale à la longueur L1 du fil 105c (ce qui correspond sensiblement à la configuration de la figure 1). Dans chaque cas, les extrémités 105c_{INT-1} et 105c_{INT-2} du tronçon intermédiaire 105c_{INT} sont disposés de façon symétrique par rapport au centre du fil 105c.

On peut observer sur les figures 3A et 3B une inflexion de la courbe V(I1) ou R(I1) lorsque le courant de polarisation I1 atteint un certain seuil. Cette inflexion correspond au passage du régime de conduction extrinsèque vers le régime de conduction intrinsèque dans le tronçon intermédiaire 105c_{INT} du fil 105c, résultant de l'auto-échauffement du fil lié à la circulation du courant de polarisation dans le fil. On observe en particulier que l'inflexion est d'autant plus prononcée que la longueur L2 du tronçon intermédiaire 105c_{INT} est courte par rapport la longueur totale L1 du fil 105c. Ceci peut s'expliquer par le fait que la température du tronçon intermédiaire 105c_{INT} du fil 105c est d'autant plus homogène que la longueur L2 du tronçon intermédiaire 105c_{INT} est courte par rapport la longueur totale L1 du fil 105c, et que par conséquent la transition du régime de conduction extrinsèque vers le régime de conduction intrinsèque est d'autant plus franche que la longueur L2 du tronçon intermédiaire 105c_{INT} est courte par rapport la longueur totale L1 du fil 105c. On peut en particulier observer sur les courbes C1 et C2 que la pente de la courbe V(I1) devient négative lorsque le courant de polarisation I1 dépasse un certain seuil, ce qui est caractéristique d'une résistance différentielle négative.

La figure 4 est un schéma électrique équivalent du dispositif de mesure de la figure 2.

Sur la figure 4, on a représenté schématiquement les métallisations 107a, 107b, 213 et 215 du dispositif de mesure. On a en outre représenté la source de courant 251, les résistances d'accès r₁₀₇ₐ et r_{107b} du circuit de contrôle 250, le capteur de tension 261, et les résistances d'accès r₂₁₃ et r₂₁₅ du circuit de contrôle 260.

Sur la figure 4, le fil semiconducteur 105c est schématisé par trois résistances R_{NW1}, R_{NW} et R_{NW2} connectées en série entre les métallisations 107a et 107b. La résistance R_{NW} correspond à la résistance du tronçon intermédiaire 105c_{INT} du fil 105c. La résistance R_{NW1} correspond à la résistance du premier tronçon latéral du fil 105c, s'étendant entre l'extrémité 105c-1 et le noeud intermédiaire 105c_{INT-1} du fil 105c, et la résistance R_{NW2} correspond à la résistance du deuxième tronçon latéral du fil 105c, s'étendant entre le noeud intermédiaire 105c_{INT-2} et l'extrémité 105c-2 du fil 105c.

On a en outre représenté sur la figure 4 une résistance R₂₀₁ reliant le point milieu entre les résistances R_{NW1} et R_{NW} à la métallisation 213, correspondant à la résistance du fil sonde 201, et une résistance R₂₀₃ reliant le point milieu entre les résistances R_{NW} et R_{NW2} à la métallisation 215, correspondant à la résistance du fil sonde 203.

On a de plus représenté sur la figure 4 une résistance R_{LOAD} reliant le noeud n4 au noeud n5, correspondant à l'impédance du dispositif de mesure de tension 261.

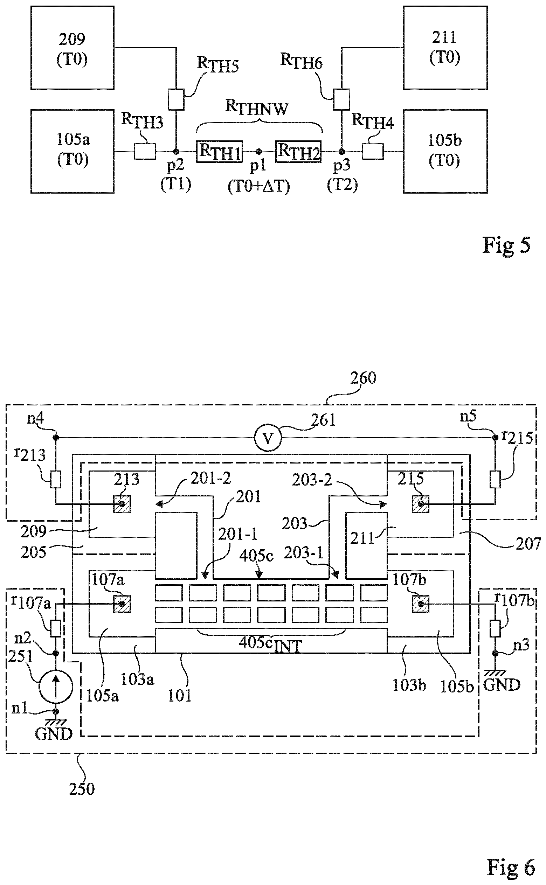

La figure 5 est un schéma thermique équivalent du dispositif de mesure de la figure 2.

Sur la figure 5, on a représenté schématiquement les régions d'ancrage 105a, 105b, 209 et 211 du dispositif de mesure. Dans cet exemple, on considère que les régions d'ancrage 105a, 105b, 209 et 211 sont à une même température T0 et forment une masse thermique du dispositif.

On a en outre représenté sur la figure 5 un point p1 correspondant au milieu du fil semiconducteur 105c, un point p2 correspondant à la première extrémité 105c_{INT-1} du tronçon intermédiaire 105c_{INT} du fil 105c, et un point p3 correspondant à la deuxième extrémité 105c_{INT-2} du tronçon intermédiaire 105c_{INT} du fil 105c. En fonctionnement, sous l'effet du courant de polarisation, le point central p1 du fil 105c monte à une température T0+ΔT supérieure à la température T0. Le point p2 monte quant à lui à une température T1 comprise entre T0 et T0+ΔT, et le point p3 monte à une température T2 comprise entre T0 et T0+ΔT, par exemple sensiblement égale à la température T1.

On a représenté sur la figure 5 une résistance thermique R_{TH1} reliant le point p2 au point p1, et une résistance thermique R_{TH2} reliant le point p1 au point p3. L'association en série des résistances R_{TH1} et R_{TH2} correspond à la résistance thermique R_{THNW} du tronçon intermédiaire 105c_{INT} du fil 105c, entre les noeuds 105c_{INT-1} et 105c_{INT-2} du fil 105c. Les résistances RTH1 et RTH2 sont par exemple chacune sensiblement égale à la moitié de la résistance R_{THNW}.

On a en outre représenté sur la figure 5 une résistance thermique R_{TH3} reliant le noeud p2 à la région d'ancrage 105a, correspondant à la résistance thermique du premier tronçon latéral du fil 105c, s'étendant entre l'extrémité 105c-1 et le noeud intermédiaire 105c_{INT-1} du fil, et une résistance thermique R_{TH4} reliant le noeud p3 à la région d'ancrage 105b, correspondant à la résistance thermique du deuxième tronçon latéral du fil 105c, s'étendant entre le noeud intermédiaire 105c_{INT-2} et l'extrémité 105c-2 du fil.

On a de plus représenté sur la figure 5 une résistance thermique R_{TH5} reliant le noeud p2 à la région d'ancrage 209, et une résistance thermique R_{TH6} reliant le noeud p3 à la région d'ancrage 211.

Afin que les dispositifs de contrôle 250 et 260 n'altèrent pas de manière significative la valeur mesurée, il convient que la résistance électrique R_{LOAD} du circuit de contrôle 260 soit relativement grande devant la résistance électrique R_{NW} du tronçon intermédiaire 105c_{INT} du fil semiconducteur 105c. Selon l'invention, les résistances thermiques R_{TH5} et R_{TH6} des fils semiconducteurs sondes 201 et 203 sont relativement grandes devant, respectivement, les résistances thermiques R_{TH3} et R_{TH4} des tronçons latéraux du fil semiconducteur 105c.

A titre d'exemple, la résistance électrique R_{LOAD} du dispositif de mesure de tension est choisie au moins dix fois supérieure, de préférence au moins cent fois supérieure, et encore plus préférentiellement au moins mille fois supérieure, à la résistance électrique R_{NW} du tronçon intermédiaire 105c_{INT} du fil 105c. A titre d'exemple, la résistance électrique R_{LOAD} du dispositif de mesure de tension est supérieure à 100 MΩ.

A titre d'exemple, la résistance thermique R_{TH5} du fil semiconducteur sonde 201 est choisie supérieure, de préférence au moins deux fois supérieure, et encore plus préférentiellement au moins dix fois supérieure, à la résistance thermique R_{TH3} du premier tronçon latéral du fil semiconducteur 105c. De façon similaire, la résistance R_{TH6} du fil semiconducteur sonde 203 peut être choisie supérieure, de préférence au moins deux fois supérieure, et encore plus préférentiellement au moins dix fois supérieure, à la résistance thermique R_{TH4} du deuxième tronçon latéral du fil semiconducteur 105c.

Pour obtenir le rapport souhaité entre la résistance thermique R_{TH5} et la résistance thermique R_{TH3}, la longueur du fil 201 peut être supérieure à la longueur du premier tronçon latéral du fil 105c (entre le noeud p2 et la région d'ancrage 105a), et/ou la largeur du fil 201 peut être inférieure à la largeur du premier tronçon latéral du fil 105c. De façon similaire, pour obtenir le rapport souhaité entre la résistance thermique R_{TH6} et la résistance thermique R_{TH4}, la longueur du fil 203 peut être supérieure à la longueur du deuxième tronçon latéral du fil 105c (entre le noeud p3 et la région d'ancrage 105b), et/ou la largeur du fil 203 peut être inférieure à la largeur du deuxième tronçon latéral du fil 105c.

La figure 6 est une vue de dessus illustrant de façon schématique un autre exemple d'un mode de réalisation d'un dispositif de mesure comportant un fil semiconducteur suspendu.

Le dispositif de la figure 6 diffère du dispositif de la figure 2 principalement en ce que, dans le dispositif de la figure 6, le fil semiconducteur 105c est remplacé par un treillis ou une grille 405c de forme générale allongée, constituée d'une pluralité de fils semiconducteurs interconnectés, reliant la région d'ancrage 105a à la région d'ancrage 105b.

A titre d'exemple, tous les fils semiconducteurs constitutifs de la grille 405c ont sensiblement la même largeur. La grille 405c comprend par exemple une pluralité de fils parallèles à la face supérieure du substrat 101 et parallèles à l'axe longitudinal de la grille, s'étendant de la région d'ancrage 105a à la région d'ancrage 105b, et une pluralité de fils parallèles à la face supérieure du substrat 101 et orthogonaux à l'axe longitudinal de la grille, reliant entre eux les fils longitudinaux.

De façon similaire à ce qui a été décrit précédemment, le circuit de contrôle 250, connecté d'une part à la métallisation 107a et d'autre part à la métallisation 107b, est adapté à appliquer un signal électrique entre les deux extrémités de la grille 405c, c'est-à-dire entre la zone de contact entre la grille 405c et la région d'ancrage 105a, et la zone de contact entre la grille 405c et la région d'ancrage 105b.

Le circuit de contrôle 250 est adapté à faire circuler un courant électrique entre les deux extrémités de la grille 405c.

De plus, de façon similaire à ce qui a été décrit ci-dessus, le circuit de contrôle 260 est agencé pour lire un deuxième signal électrique aux bornes d'un tronçon intermédiaire 405c_{INT} de la grille de fils semiconducteur 405c.

Le circuit de contrôle 260 est adapté à mesurer la tension entre les extrémités du tronçon intermédiaire 405c_{INT}, par l'intermédiaire des fils semiconducteurs sondes 201 et 203, des régions d'ancrage 209 et 211, et des métallisations de contact 213 et 215.

Dans le mode de réalisation de la figure 6 chaque fil élémentaire de la grille 405c peut présenter une section transversale de plus petite surface que le fil semiconducteur 105c de l'exemple de la figure 2, par exemple une section transversale de dimensions nanométriques (par exemple inférieure à 500 nm). Un avantage est que ceci permet d'amplifier le phénomène d'auto-échauffement du matériau semiconducteur sous l'effet du courant de polarisation, en raison d'une conduction thermique réduite.

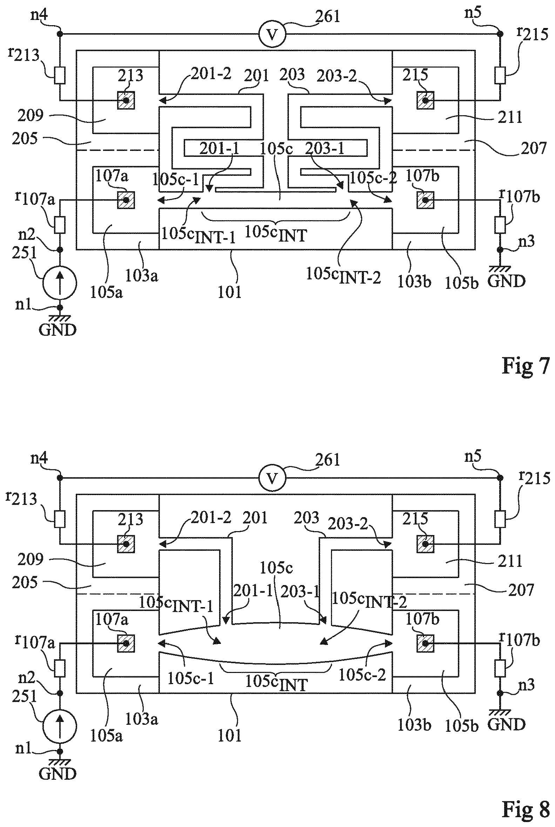

La figure 7 est une vue de dessus illustrant de façon schématique un autre exemple d'un mode de réalisation d'un dispositif de mesure comportant un fil semiconducteur suspendu.

Le dispositif de la figure 7 diffère du dispositif de la figure 2 principalement en ce que, dans le dispositif de la figure 7, les fils semiconducteurs sondes 201 et 203, reliant les extrémités du tronçon intermédiaire 105c_{INT} du fil 105c au circuit de mesure de tension 261, ont une forme en serpentin, ce qui permet d'augmenter leur longueur, et donc leur résistance thermique, sans augmenter la surface totale du dispositif.

La figure 8 est une vue de dessus illustrant de façon schématique un autre exemple d'un mode de réalisation d'un dispositif de mesure comportant un fil semiconducteur suspendu.

Le dispositif de la figure 8 diffère du dispositif de la figure 2 principalement en ce que, dans le dispositif de la figure 8, le fil semiconducteur 105c présente une largeur non-uniforme le long de l'axe longitudinal du fil. Plus particulièrement, dans le mode de réalisation de la figure 8, la largeur du fil semiconducteur 105c varie le long de l'axe longitudinal du fil de façon que, en fonctionnement, la température du tronçon intermédiaire 105c_{INT} du fil soit sensiblement uniforme sur toute sa longueur. Pour cela, la largeur du fil 105c croit progressivement depuis la première extrémité 105c-1 du fil jusqu'au centre du fil, puis décroît progressivement du centre du fil jusqu'à la deuxième extrémité 105c-2 du fil, par exemple selon un profil parabolique.

Un avantage du mode de réalisation de la figure 8 est que le tronçon intermédiaire 105c_{INT} du fil 105c change alors de régime de conduction simultanément sur toute sa longueur sous l'effet d'une variation du courant de polarisation et/ou d'une variation de la grandeur physique à mesurer, ce qui permet de réaliser des mesures particulièrement précises.

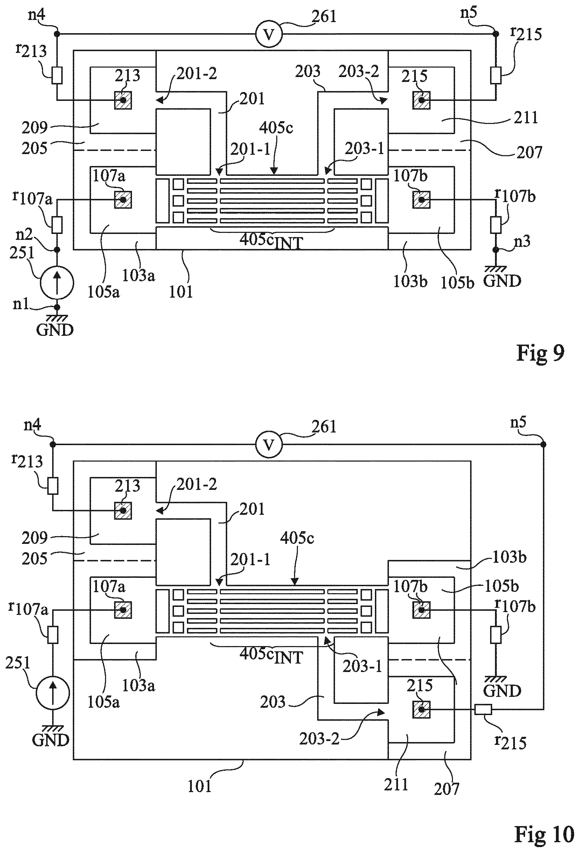

La figure 9 est une vue de dessus illustrant de façon schématique un autre exemple d'un mode de réalisation d'un dispositif de mesure comportant un fil semiconducteur suspendu.

Le dispositif de la figure 9 comprend des éléments communs avec le dispositif de la figure 6, et diffère du dispositif de la figure 6 principalement en ce que, dans le dispositif de la figure 9, la grille 405c de fils semiconducteurs présente une section totale de passage de courant non-uniforme le long de l'axe longitudinal de la grille. Plus particulièrement, dans le mode de réalisation de la figure 9, la densité de fils semiconducteurs de la grille 405c varie le long de l'axe longitudinal de la grille. Ceci permet, de façon similaire à ce qui a été décrit dans l'exemple de la figure 8, de contrôler le profil de température du tronçon intermédiaire 405c_{INT} de la grille 405. A titre d'exemple, la densité de fils semiconducteurs de la grille 405c varie le long de l'axe longitudinal de la grille 405c de façon que, en fonctionnement, la température du tronçon intermédiaire 405c_{INT} de la grille soit sensiblement uniforme sur toute sa longueur. Pour cela, dans cet exemple, le nombre de fils semiconducteurs longitudinaux de la grille dans le tronçon intermédiaire 405c_{INT} est supérieur au nombre de fils semiconducteurs longitudinaux dans les tronçons latéraux de la grille.

La figure 10 est une vue de dessus illustrant de façon schématique un autre exemple d'un mode de réalisation d'un dispositif de mesure comportant un fil semiconducteur suspendu.

Le dispositif de la figure 10 comprend des éléments communs avec le dispositif de la figure 9, et diffère du dispositif de la figure 9 principalement en ce que, dans le dispositif de la figure 10, les fils sondes 201 et 203 sont en contact avec des bords longitudinaux opposés de la grille semiconductrice 405c, alors que, dans le dispositif de la figure 9, les fils sondes 201 et 203 sont en contact avec un même bord longitudinal de la grille semiconductrice 405c.

Un avantage du dispositif de mesure la figure 10 par rapport au dispositif de mesure de la figure 9 est que le dispositif de la figure 10 permet de sonder la résistance d'une plus grande partie de la structure suspendue que le dispositif de la figure 9. Dans le cas du dispositif de la figure 9, seules les propriétés du nanofil en contact avec les fils sonde 201, 203 sont mesurées, étant entendu que les propriétés du nanofil en contact avec les fils sonde 201, 203 dépendent des propriétés de l'ensemble de la structure.

En pratique, les nanofils horizontaux des dispositifs des figures 9 et 10 peuvent être reliés entre eux par des nanofils verticaux. De préférence, comme cela apparaît sur les figures 9 et 10, chacun des fils sonde 201, 203 est en contact avec la structure 405c au niveau d'un nanofil vertical de la structure 405c. Ceci permet d'éviter ou de limiter l'apparition d'un différentiel de tension ou de température, dans la direction verticale (ou direction orthogonale à l'axe longitudinal de la structure 405c), au niveau de la zone de prise de contact pour la mesure de tension.

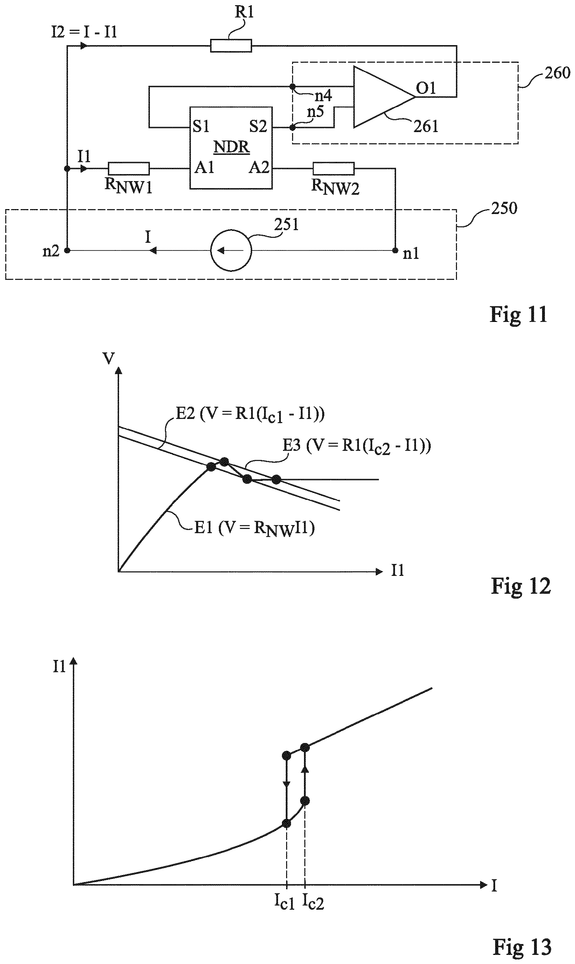

La figure 11 est un schéma électrique simplifié d'un exemple d'un mode de réalisation d'un dispositif de mesure comportant un fil semiconducteur suspendu. On considère ici par exemple un dispositif de mesure du type décrit en relation avec la figure 2, comprenant un premier circuit de contrôle 250 connecté aux extrémités du fil semiconducteur suspendu et adapté à appliquer un courant de polarisation à travers le fil, et un deuxième circuit de contrôle 260 agencé pour mesurer une tension aux bornes d'un tronçon central du fil, situé entre les première et deuxième extrémités du fil. Dans cet exemple, on prévoit plus particulièrement d'exploiter le changement de régime de conduction dans le tronçon intermédiaire du fil pour réaliser une mesure d'une grandeur physique caractéristique de l'environnement du fil.

Sur la figure 11, le tronçon central du fil semiconducteur suspendu est représenté sous la forme d'un bloc NDR comprenant deux bornes A1 et A2 par lesquelles est appliqué le courant de polarisation I1 du tronçon central du fil (les bornes A1 et A2 correspondant par exemple respectivement aux noeuds intermédiaires 105c_{INT-1} et 105c_{INT-2} dans l'exemple de la figure 2), et deux bornes S1 et S2 auxquelles est connecté le circuit de contrôle 260 mesurant la tension aux bornes du tronçon central du fil (les bornes S1 et S2 correspondant par exemple respectivement aux métallisations 213 et 215 dans l'exemple de la figure 2). On a en outre représenté sur la figure 11 des résistances électriques R_{NW1} et R_{NW2} correspondant respectivement aux tronçons latéraux du fil semiconducteur (respectivement entre la métallisation 107a et le noeud intermédiaire 105c_{INT-1} et entre la métallisation 107b et le noeud intermédiaire 105c_{INT-2} dans l'exemple de la figure 2).

Par souci de simplification, les résistances d'accès r₁₀₇ₐ et r_{107b} du circuit de contrôle 250 et les résistances d'accès r₂₁₃ et r₂₁₅ du circuit de contrôle 260 n'ont pas été représentées sur la figure 11.

Dans l'exemple de la figure 11, le circuit de contrôle 250 comprend une source de courant 251 ayant une première borne de conduction connectée à un noeud n1 du circuit 250 et une deuxième borne de conduction connecté à un noeud n2 du circuit 250. Dans cet exemple, le noeud n1 est relié à une première extrémité de la résistance R_{NW2} (éventuellement via la résistance d'accès r_{107b}, non représentée sur la figure 11), la deuxième extrémité de la résistance R_{NW2} étant connectée à la borne A2 du bloc NDR. De plus, dans cet exemple, le noeud n2 est relié à une première extrémité de la résistance R_{NW1} (éventuellement via la résistance d'accès r₁₀₇ₐ, non représentée sur la figure 11), la deuxième extrémité de la résistance R_{NW1} étant connectée à la borne A1.

Dans l'exemple de la figure 11, le circuit de contrôle 260 comprend un amplificateur de mesure de tension 261 ayant une première borne de mesure n4 reliée à la borne S1 du bloc NDR (éventuellement via la résistance d'accès r₂₁₃ non représentée sur la figure 11), et une deuxième borne de mesure n5 reliée à la borne S2 du bloc NDR (éventuellement via la résistance d'accès r₂₁₅ non représentée sur la figure 11). L'amplificateur de mesure 261 comprend une sortie O1 fournissant une tension de sortie V = V_{S2} - V_{S1}, où V_{S2} et V_{S1} désignent respectivement la tension (référencée par rapport à la masse) sur la borne S2 du bloc NDR et la tension (référencée par rapport à la masse) sur la borne S1 du bloc NDR. On notera que dans cet exemple, l'amplificateur de mesure de tension 261 est à gain unitaire. Toutefois, le dispositif de mesure de la figure 11 peut être adapté pour utiliser un amplificateur de mesure de tension de gain différent de 1. De préférence, l'amplificateur de mesure de tension 261 présente une impédance d'entrée importante pour ne pas modifier de façon significative la chute de tension mesurée.

Le dispositif de mesure de la figure 11 comprend en outre une résistance électrique R1 ayant une première extrémité reliée, par exemple connectée, à la sortie O1 de l'amplificateur de mesure 261, et une deuxième extrémité reliée, par exemple connectée, à l'extrémité de la résistance R_{NW1} opposée à la borne A1 (par exemple à la métallisation 107a dans l'exemple de la figure 2).

En fonctionnement, le circuit de contrôle 250 est commandé pour que la source de courant 251 impose un courant I déterminé entre ses noeuds de conduction n1 et n2. Une partie I1 du courant I est dérivée dans le fil semiconducteur. Le courant I1 constitue le courant de polarisation du fil semiconducteur. Le reste du courant I, c'est-à-dire un courant I2=I-I1, est dérivé par la résistance de rétroaction R1 du dispositif de mesure. En pratique, le courant I2, et donc le courant I1=I-I2, dépendent de la valeur de la tension V=V_{S2}-V_{S1} sur la borne de sortie O1 de l'amplificateur de mesure 261.

Les figures 12, 13 et 14 sont des diagrammes illustrant graphiquement le comportement du dispositif de mesure de la figure 11.

La figure 12 comprend une courbe E1 représentant l'évolution, en fonction du courant I1 (en abscisse) de la tension V (en ordonnée) aux bornes du tronçon central NDR du fil semiconducteur du dispositif, en fonction du courant de polarisation I1 circulant dans le fil semiconducteur. Comme cela apparait sur la figure 12, la courbe E1 est non monotone en raison du changement de régime de conduction dans le fil semiconducteur, qui confère au tronçon central NDR du fil une caractéristique de résistance différentielle négative. Plus particulièrement, la courbe E1 est une courbe continue comportant une phase de croissance, suivie d'une phase de décroissance, puis à nouveau une phase de croissance.

La figure 12 comprend en outre une droite E2 représentant, pour un courant de polarisation I=I_{c1} donné fourni par la source de courant 251, l'évolution, en fonction du courant I1, de la tension V=R1*(I_{c1}-I1) aux bornes de la résistance R1.

La figure 12 comprend de plus une droite E3 représentant, pour un courant de polarisation I=I_{c2} donné fourni par la source de courant 251, avec I_{c2}>I_{c1}, l'évolution, en fonction du courant I1, de la tension V=R1*(I_{c2}-I1) aux bornes de la résistance R1.

Comme cela apparaît sur la figure 12, chacune des droites E2 et E3 intersecte la courbe E1 en deux points. Autrement dit, pour chacun des courants de polarisation I=I_{c1} et I=I_{c2} du dispositif de mesure, il existe deux états de polarisation stables possibles du dispositif, c'est-à-dire que le courant I1 circulant dans le fil semiconducteur peut prendre l'une ou l'autre de deux valeurs stable, correspondant respectivement à deux valeurs distinctes de la tension V aux bornes du tronçon central du fil semiconducteur. Plus généralement, quelle que soit la valeur du courant de polarisation I entre les valeurs I_{c1} et I_{c2}, il existe deux états de polarisation stables du dispositif.

On peut en outre observer sur la figure 12 que le courant I=I_{c1} correspond au plus petit courant de polarisation du dispositif pour lequel le dispositif présente deux états de polarisation stables. En effet, pour un courant de polarisation I<I_{c1}, il existe une unique intersection de la courbe E1 avec la droite d'équation V=R1(I-I1), et donc un unique état de polarisation stable du dispositif. De plus, le courant I=I_{c2} correspond au plus fort courant de polarisation du dispositif pour lequel le dispositif présente deux états de polarisation stables. En effet, pour un courant de polarisation I>I_{c2}, il existe une unique intersection de la courbe E1 avec la droite d'équation V=R1 (I-I1) , et donc un unique état de polarisation stable du dispositif.

Ainsi, il existe une plage [I_{c1}, I_{c2}] de valeurs du courant de polarisation I dans laquelle deux états de polarisation du dispositif sont possibles, correspondant à deux répartitions différentes du courant I entre le fil semiconducteur suspendu et la résistance R1. Le dispositif de mesure de la figure 11 a donc un comportement bistable et sa réponse en courant présente une hystérésis, comme l'illustre la figure 13.

La figure 13 est un diagramme représentant l'évolution, en fonction du courant de polarisation I du dispositif de mesure (en abscisse), du courant I1 (en ordonnée) circulant dans le fil semiconducteur suspendu.

On observe sur la figure 13 que lorsque le courant I croit à partir d'une valeur inférieure à la valeur seuil I_{c1}, le courant I1 augmente de façon continue avec le courant I, jusqu'à ce que le courant I atteigne la valeur de seuil haut I_{c2}. Lorsque le courant I franchit le seuil I_{c2}, le courant I1 augmente brusquement, du fait d'un changement de répartition du courant I entre le fil semiconducteur suspendu et la résistance R1. Le courant I1 continue ensuite de croitre de façon continue en fonction du courant I.

Lorsque le courant I décroit à partir d'une valeur supérieure à la valeur seuil I_{c2}, le courant I1 diminue de façon continue avec le courant I, jusqu'à ce que le courant I atteigne la valeur de seuil bas I_{c1}. Lorsque le courant I franchit le seuil I_{c1}, le courant I1 chute brusquement, du fait d'un changement de répartition du courant I entre le fil semiconducteur suspendu et la résistance R1.

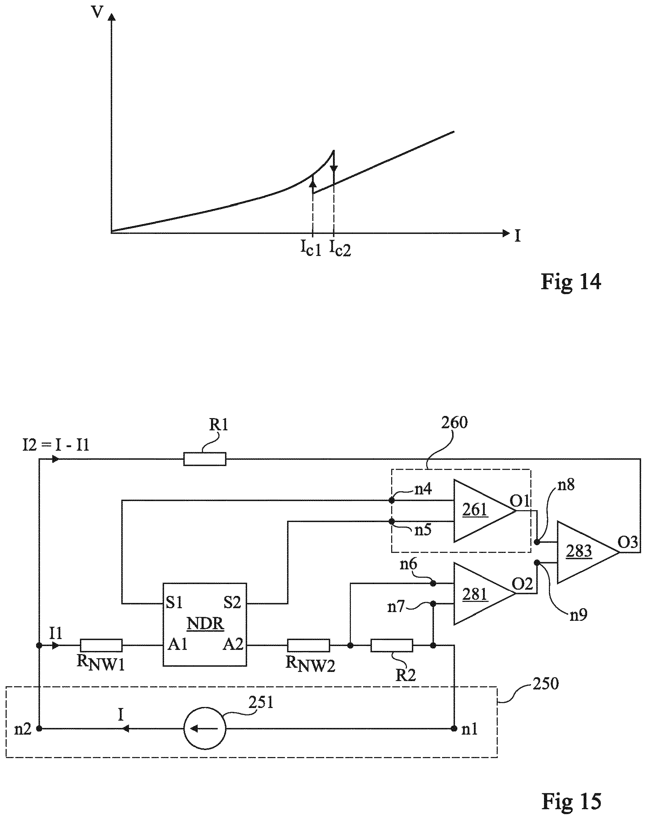

La figure 14 est un diagramme similaire au diagramme de la figure 13, représentant l'évolution, en fonction du courant de polarisation I du dispositif de mesure (en abscisse), de la tension V (en ordonnée) en sortie de l'amplificateur de mesure 261 du dispositif de la figure 11.

On observe sur la figure 14 que lorsque le courant I croit à partir d'une valeur inférieure à la valeur seuil I_{c1}, la tension V augmente de façon continue avec le courant I, jusqu'à ce que le courant I atteigne la valeur de seuil haut I_{c2}. Lorsque le courant I franchit le seuil I_{c2}, la tension V chute brusquement, du fait du changement de répartition du courant I entre le fil semiconducteur suspendu et la résistance R1. En effet, comme expliqué précédemment en relation avec la figure 13, lorsque le courant I franchit le seuil I_{c2}, le courant I1 circulant dans le fil semiconducteur suspendu augmente brusquement, ce qui entraine un échauffement significatif du fil, conduisant à un changement de régime de conduction dans le fil. Plus particulièrement, le fil semiconducteur suspendu passe du régime de conduction extrinsèque au régime de conduction intrinsèque, ce qui entraine une brusque chute de la résistance électrique du tronçon central du fil semiconducteur suspendu, et donc une chute de la tension V. La tension V continue ensuite de croitre de façon continue en fonction du courant I.

Lorsque le courant I décroit à partir d'une valeur supérieure à la valeur seuil I_{c2}, la tension V diminue de façon continue avec le courant I, jusqu'à ce que le courant I atteigne la valeur de seuil bas I_{c1}. Lorsque le courant I franchit le seuil I_{c1}, la tension V monte brusquement, du fait du changement de répartition du courant I entre le fil semiconducteur suspendu et la résistance R1. En effet, comme expliqué précédemment en relation avec la figure 13, lorsque le courant I franchit le seuil I_{c1}, le courant I1 circulant dans le fil semiconducteur suspendu chute brusquement, ce qui entraine un refroidissement du fil, conduisant à un changement de régime de conduction dans le fil. Plus particulièrement, le fil semiconducteur suspendu passe du régime de conduction intrinsèque au régime de conduction extrinsèque, ce qui entraine une brusque augmentation de la résistance électrique du tronçon central du fil semiconducteur suspendu, et donc une augmentation de la tension V. La tension V continue ensuite de décroitre de façon continue en fonction du courant I.

La figure 15 est un schéma électrique simplifié illustrant une variante du dispositif de mesure de la figure 11, dans laquelle une résistance ohmique additionnelle R2 est prévue pour ajuster la réponse électrique du fil semiconducteur suspendu.

Le dispositif de la figure 15 comprend les mêmes éléments que le dispositif de la figure 11, agencés sensiblement de la même manière, et comprend en outre une résistance électrique additionnelle R2, un amplificateur de mesure de tension additionnel 281, et un additionneur de tension non inverseur 283. La résistance R2 est connectée en série avec la résistance R_{NW2} entre la borne A2 et le noeud n1. Plus particulièrement, la résistance R2 a une première extrémité reliée, par exemple connectée, au noeud n1, et une deuxième extrémité reliée, par exemple connectée, à l'extrémité de la résistance R_{NW2} opposée à la borne A2. L'amplificateur de mesure 281 a une première borne de mesure n6 reliée, par exemple connectée, au point milieu entre les résistances R_{NW2} et R2, et une deuxième borne de mesure reliée, par exemple connectée, à l'extrémité de la résistance R2 opposée à la résistance R_{NW2}. L'additionneur 283 a quant à lui une première borne d'entrée n8 reliée, par exemple connectée, à la sortie O1 de l'amplificateur 261, et une deuxième borne d'entrée n9 reliée, par exemple connectée, à une borne de sortie O2 de l'amplificateur de mesure 281. Dans cet exemple, la résistance R1 relie le noeud n2 non pas à la borne de sortie O1 de l'amplificateur de mesure 261, mais à une borne de sortie O3 de l'additionneur 283.

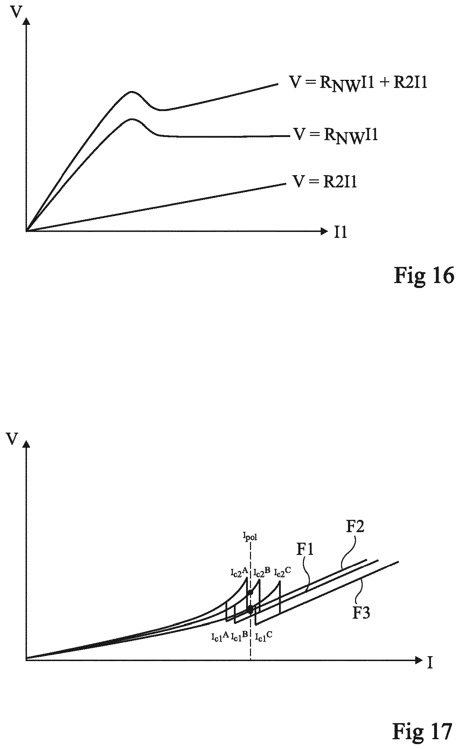

On obtient ainsi, comme l'illustre la figure 16, une caractéristique V(I) améliorée pour laquelle le saut en courant dans le fil semiconducteur suspendu est plus faible lorsque le courant I dépasse le seuil I_{c2}, ce qui permet de limiter la plage de courant dans le fil semiconducteur, et par conséquent l'échauffement de la structure.

Un exemple d'un mode de fonctionnement des dispositifs de mesure des figures 11 et 15 va maintenant être décrit.

En se référant à nouveau à la figure 14, les bornes I_{c1} et I_{c2} de la plage de courant de polarisation I pour laquelle il existe deux états de polarisation possibles du dispositif de mesure de courant dépendent de la caractéristique V=R_{NW}I1 de la tension aux bornes du tronçon intermédiaire du fil semiconducteur, et dépendent donc de manière non triviale de la valeur de la résistance R_{NW} et de la température. Une modification des échanges thermiques avec le milieu environnant, par exemple liée à une modification de pression ou de nature du gaz environnant, induit donc une modification des valeurs seuils I_{c1} et I_{c2} du courant de polarisation I. De façon similaire, une modification de la résistance R_{NW} liée à un autre paramètre que la température, par exemple par effet piézorésistif, induit une modification des valeurs seuils I_{c1} et I_{c2}. Les valeurs I_{c1} et I_{c2} dépendent en outre des paramètres électriques du circuit, et notamment de la valeur de la résistance R1 et, le cas échéant, de la résistance R2, ainsi que du gain de l'amplificateur de mesure 261 et, le cas échéant, de l'amplificateur de mesure 281.

Le fonctionnement d'un capteur selon un exemple d'un mode de réalisation est basé sur le fait qu'une variation de la grandeur physique que l'on cherche à mesurer entraine une modification des valeurs seuil I_{c1} et/ou I_{c2} du courant de polarisation I, c'est-à-dire une modification des bornes de la plage du courant de polarisation I pour laquelle il existe deux états de polarisation stables possibles du dispositif.

On appelle ici perturbation une variation de la grandeur physique à mesurer, susceptible d'entrainer une modification des seuils I_{c1} et/ou I_{c2}, étant entendu que l'on cherche ici à détecter une occurrence d'une telle perturbation.

Le courant de polarisation I du dispositif, imposé par la source de courant 251, est choisi pour que la tension V aux bornes du tronçon central du fil semiconducteur suspendu (entre les bornes S1 et S2 avec les notations de la figure 11) présente un saut (changement brusque de valeur) en présence de la perturbation.

La figure 17 illustre plus particulièrement le choix du courant de polarisation I et le fonctionnement du capteur.

Le courant I est fixé à une valeur I=Iₚₒₗ comprise entre des valeurs I_{c1}^{B} et I_{c2}^{B}, I_{c1}^{B} et I_{c2}^{B} désignant respectivement la valeur seuil I_{c1} et la valeur seuil I_{c2} en l'absence de perturbation (courbe F1 de la figure 17). A titre d'exemple, la valeur I=Iₚₒₗ est choisie sensiblement égale à (I_{c1}^{B} + I_{c2}^{B})/2.

En présence d'une perturbation conduisant à abaisser le seuil haut I_{c2} de la valeur I_{c2}^{B} à une valeur I_{c2}^{A} inférieure à I_{c2}^{B}, et à abaisser le seuil bas I_{c1} de la valeur I_{c1}^{B} à une valeur I_{c1}^{A} inférieure à I_{c1}^{B}, avec I_{c2}^{A} < Iₚₒₗ (courbe F2 de la figure 17), on observe une brusque diminution de la tension V aux bornes du tronçon central du fil semiconducteur suspendu (lié au changement de branche du point de fonctionnement sur la courbe V(I)), ce qui permet de détecter efficacement la perturbation.

On notera que pour pouvoir détecter efficacement une perturbation, il convient que celle-ci entraine un changement de branche dans la courbe à hystérésis V(I) du dispositif. Par exemple, si la perturbation conduit à rehausser le seuil haut I_{c2} de la valeur I_{c2}^{B} à une valeur I_{c2}^{C} supérieure à I_{c2}^{B}, et à rehausser le seuil bas I_{c1} de la valeur I_{c1}^{B} à une valeur I_{c1}^{C} supérieure à I_{c1}^{B}, avec I_{c1}^{C} > Iₚₒₗ (courbe F3 de la figure 17), il n'y a pas de changement de branche du point de fonctionnement sur la courbe V(I), et donc pas de saut brusque de la tension V.

Ainsi, la valeur limite de perturbation conduisant à un saut de la tension V dépend des conditions initiales, de la valeur Iₚₒₗ du courant de polarisation, et des valeurs des paramètres R1 et, le cas échéant, R2.

Le saut de la tension V aux bornes du tronçon central du fil semiconducteur suspendu peut être utilisé pour réaliser une détection du franchissement d'un seuil par la grandeur physique à mesurer, étant entendu que le seuil peut être ajusté de manière dynamique en jouant sur la valeur du courant de polarisation I.

Dans un mode de réalisation particulièrement avantageux, le circuit de contrôle 250 est commandé pour faire varier le courant de polarisation I de façon continue, par exemple de façon périodique, par exemple de façon sinusoïdale, de façon à balayer les trois plages de fonctionnement illustrées sur la figure 17. Plus particulièrement, le circuit de contrôle 250 peut être commandé pour faire varier le courant de polarisation I de façon périodique, de façon que, à chaque cycle, le courant I croisse d'une valeur basse inférieure à la plus petite valeur que peut prendre le seuil I_{c1} dans des conditions normales d'utilisation du dispositif, jusqu'à une valeur haute supérieure à la plus grande valeur que peut prendre le seuil I_{c2} dans des conditions normales d'utilisation du dispositif, puis décroisse de ladite valeur haute à ladite valeur basse. La valeur du courant I pour laquelle un saut de la tension V aux bornes du tronçon central du fil semiconducteur suspendu est observé est alors représentative de la grandeur physique à mesurer. Ainsi, à chaque période du courant de polarisation I, une mesure de la grandeur physique peut être réalisée. On peut donc réaliser un échantillonnage périodique de la grandeur physique à mesurer, à une fréquence d'échantillonnage égale à la fréquence du signal de polarisation I. Les dispositifs à fils semiconducteurs suspendus présentent l'avantage d'avoir une inertie thermique très faible, ce qui permet de réaliser un échantillonnage à une fréquence relativement élevée, par exemple supérieure à 1 kHz, par exemple comprise entre 1 kHz et 100 kHz.

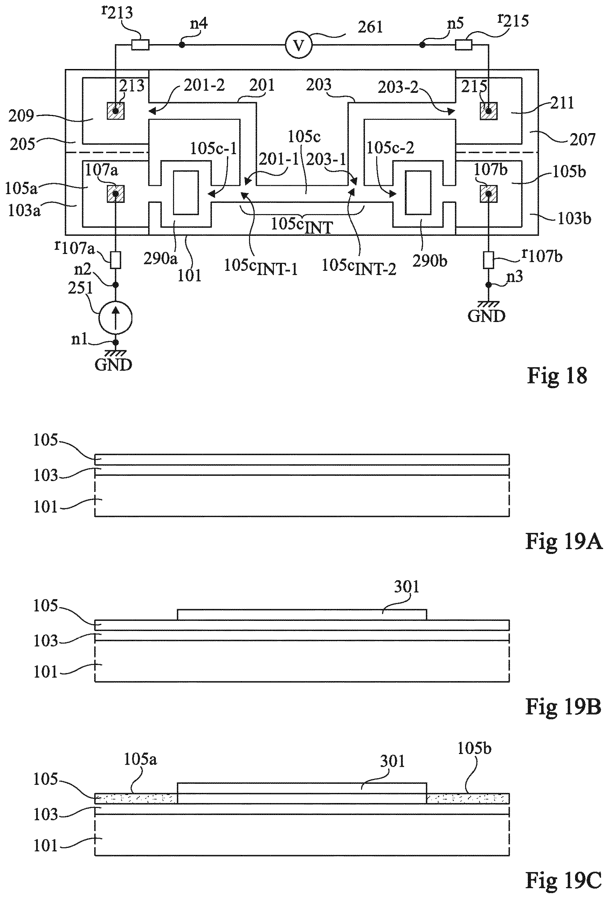

La figure 18 est une vue de dessus illustrant de façon schématique un autre exemple d'un mode de réalisation d'un dispositif de mesure comportant un fil semiconducteur suspendu.

Le dispositif de la figure 18 diffère du dispositif de la figure 2 principalement en ce que, dans le dispositif de la figure 18, les extrémités 105c-1 et 105c-2 du fil semiconducteur suspendu sont reliées aux régions d'ancrage 105a et 105b du dispositif non pas directement comme dans l'exemple de la figure 2, mais par l'intermédiaire de structures suspendues déformables 290a et 290b, adaptées à absorber d'éventuelles variations de la longueur du fil 105c sous l'effet des variations de température. Plus particulièrement, la structure 290a relie l'extrémité 105c-1 du fil 105c à la région d'ancrage 103a, et la structure 290b relie l'extrémité 105c-2 du fil 105c à la région d'ancrage 103b. Les structures 290a et 290b sont par exemple réalisées en le même matériau que le fil semiconducteur 105c. Dans l'exemple représenté, les structures 290a et 290b ont chacune, en vue de dessus, la forme d'un anneau ayant un bord extérieur fixé à une extrémité du fil 105c et un bord extérieur opposé fixé à la région d'ancrage 105a, respectivement 105b. Plus généralement, les structures déformables 290a et 290b peuvent avoir toute autre forme adaptée à se déformer lorsque la longueur du fil semiconducteur 105c varie sous l'effet de variations de température. La prévision des structures déformables 290a et 290b permet au fil semiconducteur 105c de se dilater lorsque la température varie, limitant ainsi l'apparition de contraintes dans le fil, et donc les variations parasites de résistance du fil par effet piézorésistif. Ce mode de réalisation est en particulier avantageux lorsque le dispositif est utilisé pour la caractérisation des propriétés de fils semiconducteurs suspendus à haute température.

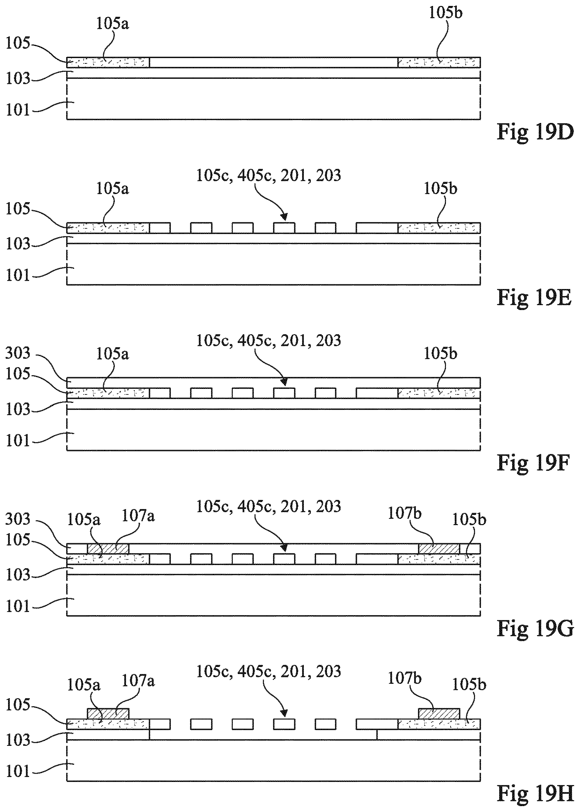

Les figures 19A, 19B, 19C, 19D, 19E, 19F, 19G et 19H sont des vues en coupe illustrant de façon schématique des étapes successives d'un exemple d'un procédé de fabrication d'un dispositif de mesure comportant un fil semiconducteur suspendu du type décrit ci-dessus.

La figure 19A illustre une structure de départ comprenant un substrat de support 101, par exemple en un matériau semiconducteur, une couche 103, par exemple en un matériau isolant, revêtant sensiblement toute la face supérieure du substrat 101, et une couche 105 en un matériau semiconducteur revêtant sensiblement toute la face supérieure de la couche 103. A titre d'exemple, la structure de départ est un empilement de type SOI (semiconducteur sur isolant), la couche 101 constituant le substrat de support de l'empilement, par exemple en silicium, la couche 103 correspondant à la couche isolante de l'empilement, par exemple en oxyde de silicium, et la couche 105 correspondant à la couche semiconductrice supérieure de l'empilement, par exemple en silicium monocristallin non intentionnellement dopé.

Les figures 19B, 19C et 19D illustrent une étape de dopage localisé, par exemple par implantation, de portions de la couche semiconductrice supérieure 105 de l'empilement. Pour cela, un masque 301 est d'abord réalisé sur la face supérieure de la couche semiconductrice 105, par exemple par photolithographie et gravure (figure 19B). A titre d'exemple, le masque 301 est en oxyde de silicium et présente une épaisseur comprise entre 50 et 100 nm. Le masque 301 comporte des ouvertures en regard des régions de la couche semiconductrice 105 que l'on souhaite doper. Une étape d'implantation d'éléments dopants à partir de la face supérieure de la structure est ensuite mise en oeuvre, le masque 301 permettant de localiser le dopage dans les régions souhaitées (figure 19C). Plus particulièrement, dans cet exemple, les portions de la couche 105 correspondant aux futures régions d'ancrage du ou des fils semiconducteurs suspendus sont dopées pour favoriser la reprise d'un contact électrique sur ces régions (via les métallisations 107a, 107b, 213, 215). Dans cet exemple, les portions de la couche 105 correspondant au(x) futur(s) fil(s) semiconducteur(s) suspendu(s) ne sont en revanche pas dopées lors de cette étape. Sur la figure 19C, seules les régions d'ancrage 105a et 105b ont été représentées. Le masque 301 est ensuite retiré (figure 19D). Une étape de recuit d'implantation peut en outre être prévue après le retrait du masque 301, par exemple à une température comprise entre 1000°C et 1100°C, pendant une durée comprise entre 30 et 90 minutes.

La figure 19E illustre une étape de gravure localisée de la couche semiconductrice 105, par exemple par photolithographie et gravure, pour délimiter les régions d'ancrage et le ou les fils semiconducteurs suspendus du dispositif. Lors de cette étape, les portions gravées de la couche 105 sont retirées sur toute l'épaisseur de la couche 105, la gravure étant interrompue sur la face supérieure de la couche 103. On notera que le motif de gravure représenté en figure 19E est purement illustratif.

La figure 19F illustre une étape de dépôt d'une couche 303 en un matériau isolant, par exemple une couche d'oxyde de silicium, sur toute la surface supérieure de la structure obtenue à l'issue des étapes des figures 19A à 19E.

La figure 19E illustre une étape de gravure d'ouvertures localisées dans la couche 303, en vis-à-vis des régions d'ancrage 105a, 105b, 209 et 211, par exemple par photolithographie et gravure, puis de dépôt d'un matériau électriquement conducteur, par exemple de l'aluminium, dans les ouvertures, pour former les bornes de prise de contact 107a, 107b, 213 et 215 du dispositif. Sur la figure 19E, seules les métallisations 107a et 107b ont été représentées.

La figure 19F illustre une étape de retrait des couches 103 et 303, par exemple par gravure chimique en phase vapeur, par exemple par gravure à la vapeur d'acide fluorhydrique, de façon à libérer le ou les fils semiconducteurs suspendus.

Des modes de réalisation particuliers ont été décrits. Diverses variantes et modifications apparaîtront à l'homme de l'art.

## Revendications

1. Dispositif de mesure comportant :
un fil semiconducteur suspendu (105c) ;
un premier circuit de contrôle (250) agencé pour appliquer un premier signal électrique entre des première (105c-1) et deuxième (105c-2) extrémités du fil semiconducteur suspendu ; et
un deuxième circuit de contrôle (260) agencé pour mesurer un deuxième signal électrique (V) entre des premier (105c_{INT-1}) et deuxième (105c_{INT-2}) noeuds intermédiaires du fil semiconducteur suspendu,
dans lequel le premier signal électrique est un courant de polarisation (I1)
entre les première (105c-1) et deuxième (105c-2) extrémités du fil semiconducteur suspendu (105c), et dans lequel le deuxième circuit de contrôle (260) est configuré pour mesurer la tension (V) entre les premier (105c_{INT-1}) et deuxième (105c_{INT-2}) noeuds intermédiaires du fil semiconducteur suspendu (105c-1),
le dispositif comprenant en outre un premier fil sonde (201) en un matériau semiconducteur, reliant le premier noeud intermédiaire (105c_{INT-1}) du fil semiconducteur suspendu (105c) à une troisième borne conductrice (213), et un deuxième fil sonde (203) en un matériau semiconducteur, reliant le deuxième noeud intermédiaire (105c_{INT-2}) du fil semiconducteur suspendu (105c) à une quatrième borne conductrice (215), le deuxième circuit de contrôle (260) étant connecté aux troisième (213) et quatrième (215) bornes conductrices,
dans lequel le premier fil sonde a une résistance thermique (R_{TH5}) supérieure à la résistance thermique (R_{TH3}) d'un premier tronçon latéral du fil semiconducteur suspendu (105c), s'étendant de la première extrémité (105c-1) du fil semiconducteur suspendu au premier noeud intermédiaire (105c_{INT-1}) du fil semiconducteur suspendu, et dans lequel le deuxième fil sonde a une résistance thermique (R_{TH6}) supérieure à la résistance thermique (R_{TH4}) d'un deuxième tronçon latéral du fil semiconducteur suspendu (105c), s'étendant de la deuxième extrémité (105c-2) du fil semiconducteur suspendu au deuxième noeud intermédiaire (105c_{INT-2}) du fil semiconducteur suspendu.

2. Dispositif de mesure selon la revendication 1, dans lequel les première (105c-1) et deuxième (105c-2) extrémités du fil semiconducteur suspendu (105c) sont fixées respectivement à des première (105a) et deuxième (105b) régions semiconductrices d'ancrage, le dispositif comportant une première borne conductrice (107a) sur et en contact avec la première région d'ancrage (105a) et une deuxième borne conductrice (107b) sur et en contact avec la deuxième région d'ancrage (105b), et le premier circuit de contrôle étant connecté aux première (107a) et deuxième (107b) bornes conductrices.

3. Dispositif de mesure selon la revendication 2, dans lequel les première (105a) et deuxième (105b) régions d'ancrage reposent respectivement sur des premier (103a) et deuxième (103b) piliers de support.

4. Dispositif de mesure selon l'une quelconque des revendications 1 à 3 , dans lequel :
le premier fil sonde (201) a une première extrémité (201-1) fixée au premier fil semiconducteur suspendu (105c) au niveau de son premier noeud intermédiaire (105c_{INT-1}) et une deuxième extrémité (201-2) fixée à une troisième région semiconductrice d'ancrage (209) ;
le deuxième fil sonde (203) a une première extrémité (203-1) fixée au premier fil semiconducteur suspendu (105c) au niveau de son deuxième noeud intermédiaire (105c_{INT-2}) et une deuxième extrémité (203-2) fixée à une quatrième région semiconductrice d'ancrage (211) ; et
les troisième (213) et quatrième (215) bornes conductrices sont respectivement sur et en contact avec la troisième région d'ancrage (209) et sur et en contact avec la quatrième région d'ancrage (211).

5. Dispositif de mesure selon la revendication 4, dans lequel les troisième (209) et quatrième (211) régions d'ancrage reposent respectivement sur des troisième (205) et quatrième (207) piliers de support de façon que le premier fil sonde (201) soit suspendu entre le troisième pilier de support (205) et le premier noeud intermédiaire (105c_{INT-1}) du fil semiconducteur suspendu (105c) et que le deuxième fil sonde (203) soit suspendu entre le quatrième pilier de support (207) et le deuxième noeud intermédiaire (105c_{INT-2}) du fil semiconducteur suspendu (105c).

6. Dispositif selon l'une quelconque des revendications 1 à 5, dans lequel la largeur du premier fil semiconducteur suspendu (105c) varie le long de l'axe longitudinal du fil.

7. Dispositif de mesure selon l'une quelconque des revendications 1 à 6, comprenant une pluralité de fils semiconducteurs suspendus interconnectés de façon à former une grille semiconductrice suspendue (405c).

8. Dispositif selon la revendication 7, dans lequel la densité de fils semiconducteurs suspendus de la grille (405c) varie selon un axe longitudinal de la grille.

9. Dispositif de mesure selon l'une quelconque des revendications 1 à 8, dans lequel le deuxième circuit de contrôle comprend un premier amplificateur de mesure de tension (261) ayant une première borne de mesure (n4) reliée au premier noeud intermédiaire (105c_{INT-1}) du fil semiconducteur suspendu (105c) et une deuxième borne de mesure (n5) reliée au deuxième noeud intermédiaire (105c_{INT-2}) du fil semiconducteur suspendu, le premier amplificateur de mesure de tension (261) comportant en outre une borne de sortie (O1) reliée à la première extrémité (105c-1) du fil semiconducteur suspendu (105c) par une première résistance (R1).

10. Dispositif de mesure selon la revendication 9, comportant en outre un deuxième amplificateur de mesure de tension (281) et un additionneur de tension (283), dans lequel :
le deuxième amplificateur de mesure de tension (281) a des première (n6) et deuxième (n7) bornes de mesure reliées respectivement à des première et deuxième extrémités d'une deuxième résistance (R2) connectée en série avec le fil semiconducteur suspendu (105c) ;
l'additionneur de tension (283) a des première (n8) et deuxième (n9) bornes d'entrée reliées respectivement à la borne de sortie (O1) du premier amplificateur (261) et à une borne de sortie (O2) du deuxième amplificateur (281) ; et
l'additionneur de tension (283) comporte une borne de sortie (O3) reliée à la première extrémité (105c-1) du fil semiconducteur suspendu (105c) par la première résistance (R1).

11. Dispositif de mesure selon la revendication 9 ou 10, dans lequel, en fonctionnement, le courant de polarisation (I1) est une première partie d'un courant de polarisation (I) fourni par le premier circuit de contrôle, et le premier circuit de contrôle fournit une deuxième partie (I2) du courant de polarisation qui est dérivée par la première résistance (R1), les valeurs des première (I1) et deuxième (I2) parties du courant de polarisation étant fonction de la valeur de la tension sur l'extrémité de la première résistance opposée à la première extrémité (105c-1) du fil semiconducteur suspendu (105c).

12. Dispositif de mesure selon la revendication 11, dans lequel le courant de polarisation (I) fourni par le premier circuit de contrôle est choisi de façon qu'il existe deux états de polarisation stables du dispositif, c'est-à-dire deux répartitions possibles du courant de polarisation (I) entre le fil semiconducteur suspendu (105c) et la première résistance (R1).

13. Dispositif de mesure selon la revendication 12, dans lequel le deuxième circuit de contrôle est configuré pour détecter un changement brusque de l'état de polarisation du dispositif, correspondant à un franchissement d'un seuil par une grandeur physique caractéristique de l'environnement du fil semiconducteur (105c) .

14. Dispositif de mesure selon l'une quelconque des revendications 1 à 13, dans lequel le premier circuit de contrôle (250) est configuré pour fournir un courant de polarisation variable de façon périodique.

## Patentansprüche

1. Eine Messvorrichtung, die Folgendes aufweist:
einen aufgehängten Halbleiterdraht (105c);
eine erste Steuerschaltung (250) ausgelegt zum Anlegen eines ersten elektrischen Signals zwischen einem ersten (105c-1) und einem zweiten (105c-2) Ende des aufgehängten Halbleiterdrahtes; und
eine zweite Steuerschaltung (260) ausgelegt zum Messen eines zweiten elektrisches Signals (V) zwischen ersten (105c_{INT-1}) und zweiten (105c_{INT-2}) Zwischenknoten des aufgehängten Halbleiterdrahtes,
wobei das erste elektrische Signal ein Vorspannungsstrom (I1) zwischen dem ersten (105c-1) und dem zweiten (105c-2) Ende des aufgehängten Halbleiterdrahtes (105c) ist, und wobei die zweite Steuerschaltung (260) konfiguriert ist zum Messen der Spannung (V) zwischen dem ersten (105c_{INT-1}) und dem zweiten (105c_{INT-2}) Zwischenknoten des aufgehängten Halbleiterdrahtes (105c-1) zu messen,
wobei die Vorrichtung ferner Folgendes aufweist: einen ersten Sondendraht (201) aus einem Halbleitermaterial aufweist, der den ersten Zwischenknoten (105c_{INT-1}) des aufgehängten Halbleiterdrahtes (105c) mit einem dritten leitenden Anschluss (213) verbindet, und einen zweiten Sondendraht (203) aus einem Halbleitermaterial, der den zweiten Zwischenknoten (105c_{INT-2}) des aufgehängten Halbleiterdrahtes (105c) mit einem vierten leitenden Anschluss (215) verbindet, wobei die zweite Steuerschaltung (260) mit dem dritten (213) und dem vierten (215) leitenden Anschluss verbunden ist,
wobei der erste Sondendraht einen Wärmewiderstand (R_{TH5}) aufweist, der höher ist als der Wärmewiderstand (R_{TH3}) eines ersten seitlichen Abschnitts des aufgehängten Halbleiterdrahtes (105c), der sich vom ersten Ende (105c-1) des aufgehängten Halbleiterdrahtes zum ersten Zwischenknoten (105c_{INT-1}) des aufgehängten Halbleiterdrahtes erstreckt, und wobei der zweite Sondendraht einen Wärmewiderstand (R_{TH6}) aufweist, der größer ist als der Wärmewiderstand (R_{TH4}) eines zweiten seitlichen Abschnitts des aufgehängten Halbleiterdrahtes (105c), der sich von dem zweiten Ende (105c-2) des aufgehängten Halbleiterdrahtes zu dem zweiten Zwischenknoten (105c_{INT-2}) des aufgehängten Halbleiterdrahtes erstreckt.

2. Messvorrichtung nach Anspruch 1, wobei das erste (105c-1) und das zweite (105c-2) Ende des aufgehängten Halbleiterdrahtes (105c) jeweils an einem ersten (105a) und einem zweiten (105b) halbleitenden Verankerungsbereich befestigt sind, wobei die Vorrichtung einen ersten leitenden Anschluss (107a) an und in Kontakt mit dem ersten Verankerungsbereich (105a) und einen zweiten leitenden Anschluss (107b) an und in Kontakt mit dem zweiten Verankerungsbereich (105b) aufweist, und wobei die erste Steuerschaltung mit dem ersten (107a) und dem zweiten (107b) leitenden Anschluss verbunden ist.

3. Messvorrichtung nach Anspruch 2, wobei der erste (105a) und der zweite (105b) Verankerungsbereich auf einer ersten (103a) bzw. zweiten (103b) Stützsäule liegen.

4. Messvorrichtung nach einem der Ansprüche 1 bis 3, wobei:
der erste Sondendraht (201) ein erstes Ende (201-1) aufweist, das an dem ersten aufgehängten Halbleiterdraht (105c) an seinem ersten Zwischenknoten (105c_{INT-1}) befestigt ist, und ein zweites Ende (201-2), das an einer dritten halbleitenden Verankerungsfläche (209) befestigt ist;
der zweite Sondendraht (203) ein erstes Ende (203-1) aufweist, das an dem ersten aufgehängten Halbleiterdraht (105c) an seinem zweiten Zwischenknoten (105c_{INT-2}) befestigt ist, und ein zweites Ende (203-2), das an einem vierten halbleitenden Verankerungsbereich (211) befestigt ist; und
der dritte (213) und der vierte (215) leitende Anschluss an und in Kontakt mit der dritten Verankerungsfläche (209) bzw. der vierten Verankerungsfläche (211) vorgesehen sind.

5. Messvorrichtung nach Anspruch 4, wobei der dritte (209) und der vierte (211) Verankerungsbereich auf dritten (205) bzw. vierten (207) Stützpfeiler liegen, so dass der erste Sondendraht (201) zwischen dem dritten Stützpfeiler (205) und dem ersten Zwischenknoten (105c_{INT-1}) des aufgehängten Halbleiterdrahtes (105c) aufgehängt ist und der zweite Sondendraht (203) zwischen dem vierten Stützpfeiler (207) und dem zweiten Zwischenknoten (105c_{INT-2}) des aufgehängten Halbleiterdrahtes (105c) aufgehängt ist.

6. Vorrichtung nach einem der Ansprüche 1 bis 5, wobei die Breite des ersten aufgehängten Halbleiterdrahtes (105c) entlang der Längsachse des Drahtes variiert, so dass im Betrieb die Temperatur zwischen dem ersten (105c_{INT-1}) und dem zweiten (105c_{INT-2}) Zwischenknoten des aufgehängten Halbleiterdrahtes im Wesentlichen gleichmäßig ist.

7. Messvorrichtung nach einem der Ansprüche 1 bis 6, aufweisend eine Vielzahl von aufgehängten Halbleiterdrähten, die so miteinander verbunden sind, dass sie ein aufgehängtes Halbleitergitter (405c) bilden.

8. Vorrichtung nach Anspruch 7, wobei die Dichte der aufgehängten Halbleiterdrähte des Gitters (405c) entlang einer Längsachse des Gitters variiert.

9. Messvorrichtung nach einem der Ansprüche 1 bis 8, wobei die zweite Steuerschaltung einen ersten Spannungsmessverstärker (261) mit einem ersten Messanschluss (n4), der mit dem ersten Zwischenknoten (105c_{INT-1}) des aufgehängten Halbleiterdrahtes (105c) gekoppelt ist, und einem zweiten Messanschluss (n5), der mit dem zweiten Zwischenknoten (105c_{INT-2}) des aufgehängten Halbleiterdrahtes gekoppelt ist, aufweist, wobei der erste Spannungsmessverstärker (261) ferner einen Ausgangsanschluss (O1) aufweist, der mit dem ersten Ende (105c-1) des aufgehängten Halbleiterdrahtes (105c) über einen ersten Widerstand (R1) gekoppelt ist.

10. Messvorrichtung nach Anspruch 9, ferner aufweisend einen zweiten Spannungsmessverstärker (281) und einen Spannungsaddierer (283), wobei:
der zweite Spannungsmessverstärker (281) einen ersten (n6) und einen zweiten (n7) Messanschluss aufweist, die mit einem ersten bzw. einem zweiten Ende eines zweiten Widerstands (R2) gekoppelt sind, der in Reihe mit der aufgehängten Halbleiterleitung (105c) geschaltet ist;
der Spannungsaddierer (283) einen ersten (n8) und einen zweiten (n9) Eingangsanschluss hat, die mit dem Ausgangsanschluss (O1) des ersten Verstärkers (261) bzw. mit einem Ausgangsanschluss (O2) des zweiten Verstärkers (281) gekoppelt sind; und
der Spannungsaddierer (283) einen Ausgangsanschluss (O3) aufweist, der über den ersten Widerstand (R1) mit dem ersten Ende (105c-1) des aufgehängten Halbleiterdrahtes (105c) verbunden ist.

11. Messvorrichtung nach Anspruch 9 oder 10, wobei während des Betriebs der Vorspannungsstrom (I1) ein erster Teil eines Vorspannungsstroms (I) ist, der von der ersten Steuerschaltung bereitgestellt wird, und die erste Steuerschaltung einen zweiten Teil (I2) des Vorspannungsstroms bereitstellt, der durch den ersten Widerstand (R1) umgelenkt wird, wobei die Werte des ersten (I1) und des zweiten (I2) Teils des Vorspannungsstroms von dem Wert der Spannung an dem Ende des ersten Widerstands gegenüber dem ersten Ende (105c-1) des aufgehängten Halbleiterdrahts (105c) abhängig sind.

12. Messvorrichtung nach Anspruch 11, wobei der von der ersten Steuerschaltung gelieferte Vorspannungsstrom (I) so gewählt wird, dass es zwei stabile Vorspannungszustände der Vorrichtung gibt, d.h. zwei mögliche Verteilungen des Vorspannungsstroms (I) zwischen dem aufgehängten Halbleiterdraht (105c) und dem ersten Widerstand (R1).

13. Messvorrichtung nach Anspruch 12, wobei die zweite Steuerschaltung konfiguriert ist zum Detektieren einer abrupte Änderung des Vorspannungszustands der Vorrichtung, entsprechend einem Überschreiten eines Schwellenwerts durch eine physikalische, variable Charakteristik der Umgebung des Halbleiterdrahts (105c).

14. Messvorrichtung nach einem der Ansprüche 1 bis 13, wobei die erste Steuerschaltung (250) so konfiguriert ist, dass sie einen periodisch variablen Vorspannungsstrom bereitstellt.

## Claims

1. A measurement device comprising:
a suspended semiconductor wire (105c);
a first control circuit (250) designed to apply a first electrical signal between first (105c-1) and second (105c-2) ends of the suspended semiconductor wire; and
a second control circuit (260) designed to measure a second electrical signal (V) between first (105c_{INT-1}) and second (105c_{INT-2}) intermediate nodes of the suspended semiconductor wire,
wherein the first electrical signal is a bias current (I1) between the first (105c-1) and second (105c-2) ends of the suspended semiconductor wire (105c), and wherein the second control circuit (260) is configured to measure the voltage (V) between the first (105c_{INT-1}) and second (105c_{INT-2}) intermediate nodes of the suspended semiconductor wire (105c-1),
the device further comprising a first probe wire (201) made of a semiconductor material, coupling the first intermediate node (105c_{INT-1}) of the suspended semiconductor wire (105c) to a third conductive terminal (213), and a second probe wire (203) made of a semiconductor material, coupling the second intermediate node (105c_{INT-2}) of the suspended semiconductor wire (105c) to a fourth conductive terminal (215), the second control circuit (260) being connected to the third (213) and fourth (215) conductive terminals,
wherein the first probe wire has a thermal resistance (R_{TH5}) higher than the thermal resistance (R_{TH3}) of a first lateral section of the suspended semiconductor wire (105c), extending from the first end (105c-1) of the suspended semiconductor wire to the first intermediate node (105c_{INT-1}) of the suspended semiconductor wire, and wherein the second probe wire has a thermal resistance (R_{TH6}) greater than the thermal resistance (R_{TH4}) of a second lateral section of the suspended semiconductor wire (105c), extending from the second end (105c-2) of the suspended semiconductor wire to the second intermediate node (105c_{INT-2}) of the suspended semiconductor wire.

2. The measurement device according to claim 1, wherein the first (105c-1) and second (105c-2) ends of the suspended semiconductor wire (105c) are respectively fixed to first (105a) and second (105b) semiconducting anchoring areas, the device comprising a first conductive terminal (107a) on and in contact with the first anchoring area (105a) and a second conductive terminal (107b) on and in contact with the second anchoring area (105b), and the first control circuit being connected to the first (107a) and second (107b) conductive terminals.

3. The measurement device according to claim 2, wherein the first (105a) and second (105b) anchoring areas respectively lie on first (103a) and second (103b) support pillars.

4. The measurement device according to any of claims 1 to 3, wherein:
the first probe wire (201) has a first end (201-1) fixed to the first suspended semiconductor wire (105c) at its first intermediate node (105c_{INT-1}) and a second end (201-2) fixed to a third semiconducting anchoring area (209);
the second probe wire (203) has a first end (203-1) fixed to the first suspended semiconductor wire (105c) at its second intermediate node (105c_{INT-2}) and a second end (203-2) fixed to a fourth semiconducting anchoring area (211); and
the third (213) and fourth (215) conductive terminals are respectively on and in contact with the third anchoring area (209) and on and in contact with the fourth anchoring area (211).

5. The measurement device according to claim 4, wherein the third (209) and fourth (211) anchoring areas respectively lie on third (205) and fourth (207) support pillars so that the first probe wire (201) is suspended between the third support pillar (205) and the first intermediate node (105c_{INT-1}) of the suspended semiconductor wire (105c) and so that the second probe wire (203) is suspended between the fourth support pillar (207) and the second intermediate node (105c_{INT-2}) of the suspended semiconductor wire (105c).

6. The device according to any of claims 1 to 5, wherein the width of the first suspended semiconductor wire (105c) varies along the longitudinal axis of the wire so that, during operation, the temperature between the first (105c_{INT-1}) and second (105c_{INT-2}) intermediate nodes of the suspended semiconductor wire is substantially uniform.

7. The measurement device according to any of claims 1 to 6, comprising a plurality of suspended semiconductor wires that are interconnected so as to form a suspended semiconducting grid (405c) .

8. The device according to claim 7, wherein the density of suspended semiconductor wires of the grid (405c) varies along a longitudinal axis of the grid.

9. The measurement device according to any of claims 1 to 8, wherein the second control circuit comprises a first voltage measurement amplifier (261) having a first measurement terminal (n4) coupled to the first intermediate node (105c_{INT-1}) of the suspended semiconductor wire (105c) and a second measurement terminal (n5) coupled to the second intermediate node (105c_{INT-2}) of the suspended semiconductor wire, the first voltage measurement amplifier (261) further comprising an output terminal (O1) coupled to the first end (105c-1) of the suspended semiconductor wire (105c) by a first resistor (R1).

10. The measurement device according to claim 9, further comprising a second voltage measurement amplifier (281) and a voltage adder (283), wherein:
the second voltage measurement amplifier (281) has first (n6) and second (n7) measurement terminals respectively coupled to first and second ends of a second resistor (R2) connected in series with the suspended semiconductor wire (105c);
the voltage adder (283) has first (n8) and second (n9) input terminals respectively coupled to the output terminal (O1) of the first amplifier (261) and to an output terminal (O2) of the second amplifier (281); and
the voltage adder (283) comprises an output terminal (O3) coupled to the first end (105c-1) of the suspended semiconductor wire (105c) by the first resistor (R1).

11. The measurement device according to claim 9 or 10, wherein, during operation, the bias current (I1) is a first part of a bias current (I) provided by the first control circuit, and the first control circuit provides a second part (12) of the bias current that is deviated by the first resistor (R1), the values of the first (I1) and second (12) parts of the bias current being dependent on the value of the voltage on the end of the first resistor opposite the first end (105c-1) of the suspended semiconductor wire (105c).

12. The measurement device according to claim 11, wherein the bias current (I) provided by the first control circuit is chosen so that there are two stable bias states of the device, i.e. two possible distributions of the bias current (I) between the suspended semiconductor wire (105c) and the first resistor (R1) .

13. The measurement device according to claim 12, wherein the second control circuit is configured to detect an abrupt change in the bias state of the device, corresponding to a crossing of a threshold by a physical variable characteristic of the environment of the semiconductor wire (105c).

14. The measurement device according to any of claims 1 to 13, wherein the first control circuit (250) is configured to provide a periodically variable bias current.
